# EUROPEAN PATENT APPLICATION

(11) **EP 4 804 770 A1**
(43) Date of publication of application: **09.09.2026**
(21) Application number: 24886348.2
(22) Date of filing: 01.11.2024
(51) Int. Cl.: H10H 20/855, H10H 20/85, H10H 20/851, H01L 25/075

(54) **LIGHT-EMITTING DEVICE**

(30) Priority: 01.11.2023 US 202363595125 P; 31.10.2024 US 202418933742
(71) Applicant: Seoul Semiconductor Co., Ltd., Gyeonggi-do 15429 (KR)
(72) Inventor: JANG, Bo Ram I, Ansan-si, Gyeonggi-do 15429 (KR); KIM, Yang Joong, Ansan-si, Gyeonggi-do 15429 (KR)
(74) Representative: Stolmár & Partner Patentanwälte PartG mbB
(86) International application number: PCT/KR2024/017041
(87) International publication number: WO 2025/095677

(57) **Abstract**

A light emitting apparatus is provided that includes a substrate, a light emitting device, a first light transmitting layer, and a first reflector. The light emitting device may be disposed on the substrate, and may emit light. The first light transmitting layer may be disposed on the substrate to cover the light emitting device, and may be formed of a material that transmit light emitted from the light emitting device. The first reflector may be disposed on at least a region of an upper surface of the first light transmitting layer, and may reflect at least a portion of light. In addition, the side surface of the first light transmitting layer includes an inclined surface.

## Description

### [Technical Field]

The present disclosure relates to a light emitting apparatus.

### [Background Art]

A light emitting diode is an inorganic semiconductor device that emits light through the recombination of electrons and holes. Recently, the light emitting diode has been widely used in various technical fields, such as display apparatuses, vehicle lamps, and general lighting. The light emitting diode has the advantages of a longer lifespan, a lower power consumption, and a faster response speed compared to a conventional light source, and it has been quickly replacing the conventional light source due to those advantages.

### [Disclosure]

### [Technical Problem]

Exemplary embodiments of the present disclosure to solve technical problems are directed to a light emitting apparatus with improved side emission efficiency.

Exemplary embodiments of the present disclosure to solve technical problems are directed to a light emitting apparatus that is configured to adjust light emitting characteristics.

Exemplary embodiments of the present disclosure to solve technical problems are directed to a structure of a light emitting apparatus that is configured to improve reliability by delaying moisture penetration into an interior of the light emitting apparatus through increasing a length of a moisture penetration path.

Exemplary embodiments of the present disclosure to solve technical problems are directed to a structure of a light emitting apparatus that is configured to reduce stress due to external pressure and to improve structural stability.

Exemplary embodiments of the present disclosure to solve technical problems are directed to a structure of a light emitting apparatus that is configured to prevent discoloration of the light emitting apparatus by increasing light stability and increasing resistance to yellowing phenomenon using a reflector.

Exemplary embodiments of the present disclosure to solve technical problems are directed to a structure of a light emitting apparatus that is configured to increase an amount of light emitted to the outside by reducing a loss of side light of a light emitting device.

Exemplary embodiments of the present disclosure to solve technical problems are directed to a structure of a light emitting apparatus having high color purity by reducing chromatic aberration of side light of a light emitting device.

### [Technical Solution]

According to an embodiment of the present disclosure, a light emitting apparatus is provided, which includes a substrate, a light emitting device, a first light transmitting layer and a first reflector. The light emitting device may be disposed on the substrate, and may emit light. The first light transmitting layer may be formed on the substrate to cover at least a surface the light emitting device, and may be formed of a material that transmits the light. The first reflector may be formed to cover at least a region of an upper surface of the first light transmitting layer, and may reflect at least some amount of the light. In addition, a side surface of the first light transmitting layer may include an inclined surface.

According to an embodiment, a main light emitting surface of the light apparatus is at least a surface, of the surfaces of the first light transmitting layer, that is separated from the first reflector.

In an embodiment, the first light transmitting layer may have a lower angle of the first light transmitting layer formed by the side surface of the first light transmitting layer and an upper surface of the substrate, and the lower angle of the first light transmitting layer may be an obtuse angle.

In addition, the first light transmitting layer may have an upper angle of the first light transmitting layer formed by the side surface of the first light transmitting layer and a lower surface of the first reflector, and the lower angle of the first light transmitting layer may be larger than the upper angle of the first light transmitting layer.

In another embodiment, the first light transmitting layer may have a lower angle of the first light transmitting layer formed by the side surface of the first light transmitting layer and the upper surface of the substrate, and the lower angle of the first light transmitting layer may be an acute angle.

In addition, the first light transmitting layer may have an upper angle of the first light transmitting layer formed by the side surface of first light transmitting layer and the lower surface of the first reflector, and the lower angle of the first light transmitting layer may be larger than the upper angle of the first light transmitting layer.

In addition, Irregularities may be formed on the side surface of the first light transmitting layer.

The lower surface of the first reflector may be in close contact with the upper surface of the first light transmitting layer.

In a right triangle formed by a hypotenuse formed by a side surface of the first light transmitting layer, a base extended from a lower surface of the first light transmitting layer and a height extended vertically from the base and contacting an end of the hypotenuse, a length of the base may be less than a length of the height.

A thickness of the first light transmitting layer may be larger than that of the first reflector.

The thickness of the first light transmitting layer may be greater than that of the substrate.

A side surface of the light emitting device may have a side inclination angle of the light emitting device formed with the upper surface of the substrate. In addition, a side surface of the first light transmitting layer opposite to a side surface of the light emitting device may have a lower angle of the first light transmitting layer formed with the upper surface of the substrate. In this case, the side inclination angle of the light emitting device and the lower angle of the first light transmitting layer may be different from each other.

For example, the side inclination angle of the light emitting device may be smaller than the lower angle of the first light transmitting layer.

The upper surface of the first light transmitting layer may include a concave region in a downward direction.

The first light transmitting layer may have a height in at least a region of the upper surface that decreases toward a center thereof.

A region of the first light transmitting layer may have a curvature.

A first extension line angle formed by a tangent line of the upper surface of the first light transmitting layer and an extension line of the upper surface of the substrate may become smaller from an outer side of the first light transmitting layer to the center thereof.

The first extension line angle at the center of the first light transmitting layer may be 0 degrees.

The tangent line of the upper surface of the first light transmitting layer may be parallel to the upper surface of the substrate at the center of the first light transmitting layer.

The first reflector may include a convex region in a downward direction corresponding to the concave region of the upper surface of the first light transmitting layer.

The first reflector may include a region that becomes gradually thicker toward a center thereof.

A second extension line angle formed by a tangent line of the lower surface of the first reflector and the extension line of the upper surface of the substrate may become smaller from the outer side of the first light transmitting layer to a center thereof.

The first reflector may have a maximum thickness in a region close to an upper surface of the light emitting device.

The inclined surface of the first light transmitting layer may be positioned in an upper region of the first light transmitting layer, and may include a first inclined surface adjacent to the first reflector.

The inclined surface of the first light transmitting layer may further include a second inclined surface having an inclination different from that of the first inclined surface, and positioned between the first inclined surface and the substrate.

The first reflector may have an inclined surface. An angle formed by an extension line of the inclined surface of the first reflector with the substrate may be smaller than an angle formed by the first inclined surface and the second inclined surface.

The light emitting apparatus may further include a second reflector spaced apart from the light emitting device.

The second reflector may be disposed in the inside of the first light transmitting layer and may be formed to surround the light emitting device.

The light emitting apparatus may further include a second light transmitting layer that transmits the light.

The light emitting apparatus may further include a third reflector covering at least a region of the side surface of the first light transmitting layer.

The third reflector may include an inner surface in contact with the first light transmitting layer and an outer surface opposite to the inner surface. An angle of the outer surface of the third reflector may be greater than that of the inner surface of the third reflector.

The first light transmitting layer may have at least a region exposed to the outside.

A light emitting apparatus according to another embodiment of the present disclosure may include a substrate, a light emitting device, a first light transmitting layer, a first reflector, and a second reflector. The light emitting device may be disposed on the substrate, and may emit light. The first light transmitting layer may be formed on the substrate to cover the light emitting device, and may be formed of a material that transmits light. The first reflector may be formed to cover at least a region of an upper surface of the first light transmitting layer, and may reflect at least a portion of the light. The second reflector may be formed on the substrate inside the first light transmitting layer, and may be formed to surround a side surface of the light emitting device. Herein, a side surface of the first light transmitting layer may be a main emitting surface through which the light of the light emitting device is emitted to the outside. The side surface of the first light transmitting layer may include an inclined surface. In addition, an inner surface of the second reflector and the side surface of the light emitting device may be spaced apart.

The second reflector may reflect a portion of light and transmit another portion of light.

The second reflector may include an inclined surface in which at least one of the inner surface or an outer surface thereof forms an acute angle with a lower surface of the second reflector.

The second reflector may include an inclined surface in which at least one of the inner surface or the outer surface forms an obtuse angle with a lower surface of the substrate.

A thickness of the second reflector may become smaller as a distance from the substrate increases. Herein, the thickness of the second reflector is a distance between an upper surface and the lower surface thereof.

A lower angle of the second reflector lower formed by the lower surface of the second reflector and an upper surface of the substrate may be different from a lower angle of the first light transmitting layer formed by the side surface of the first light transmitting layer and the upper surface of the substrate.

The second reflector may include a flat upper surface, and the flat upper surface may be parallel to a region of the first reflector.

The side surface of the first light transmitting layer and the upper surface of the second reflector may form a first angle. In addition, an outer surface of the second reflector and the upper surface of the substrate may form a second angle. In this case, a difference between the first angle and the second angle may be less than 15 degrees.

The second reflector may include a first region and a second region having different heights from the substrate.

The first region of the second reflector may be surrounded by the first light transmitting layer.

An outer surface of the first region of the second reflector may have a third angle with the flat upper surface of the second reflector, and the third angle may be greater than the first angle.

A height of the second reflector may be greater than that of the light emitting device. Alternatively, depending on an embodiment, the height of the second reflector may be smaller than that of the light emitting device. The heights of the second reflector and the light emitting device may be defined in a direction away from a surface of the substrate.

The light emitting apparatus may further include a second light transmitting layer which is formed in an inner space of the second reflector to cover the light emitting device, and transmit the light.

The second light transmitting layer may further include a filler.

An upper surface of the second light transmitting layer may have an irregular structure by the filler.

The first light transmitting layer may have a lower angle of the first light transmitting layer formed by the side surface of the first light transmitting layer and the upper surface of the substrate, and the lower angle of the first light transmitting layer may be an obtuse angle.

In addition, the first light transmitting layer may have an upper angle of the first light transmitting layer formed by the side surface of first light transmitting layer and a lower surface of the first reflector, and the lower angle of the first light transmitting layer may be larger than the upper angle of the first light transmitting layer.

Alternatively, the lower angle of the first light transmitting layer may be an acute angle.

In addition, the first light transmitting layer may have an upper angle of the first light transmitting layer formed by the side surface of first light transmitting layer and the lower surface of the first reflector, and the lower angle of the first light transmitting layer may be smaller than the upper angle of the first light transmitting layer.

Irregularities may be formed on the side surface of the first light transmitting layer.

The lower surface of the first reflector may be in close contact with the upper surface of the first light transmitting layer.

A side surface of the light emitting device may have a side inclination angle of the light emitting device formed with the upper surface of the substrate. A side surface of the first light transmitting layer opposite to a side surface of the light emitting device may have a lower angle of the first light transmitting layer formed with the upper surface of the substrate. In this case, the side inclination angle of the light emitting device and the lower angle of the first light transmitting layer may be different from each other.

The upper surface of the first light transmitting layer may include a concave region in a downward direction.

The first light transmitting layer may have a height in at least a region of the upper surface that decreases toward a center thereof.

A region of the first light transmitting layer may have a curvature.

The first reflector may include a convex region in a downward direction corresponding to the concave region of the upper surface of the first light transmitting layer.

An extension line angle formed by a tangent line of the lower surface of the first reflector and an extension line of the upper surface of the substrate may become smaller from an outer side of the first light transmitting layer to a center thereof.

The first reflector may have a maximum thickness in a region close to an upper surface of the light emitting device.

The inclined surface of the first light transmitting layer may be positioned in an upper region of the first light transmitting layer, and may include a first inclined surface adjacent to the first reflector.

The inclined surface of the first light transmitting layer may further include a second inclined surface having an inclination different from that of the first inclined surface, and positioned between the first inclined surface and the substrate.

The light emitting apparatus may further include a third reflector covering at least a region of the side surface of the first light transmitting layer.

The first light transmitting layer may have at least a region exposed to the outside.

The exposed region of the first light transmitting layer may have an inclination.

According to an embodiment of the present disclosure, a light emitting apparatus is provided, which includes a substrate, a light emitting device, a first light transmitting layer, and a first reflector. The light emitting device may be disposed on the substrate, and may emit light. The first light transmitting layer may be formed on the substrate to cover at least a surface of the light emitting device, and may be formed of a material that transmits light. The first reflector may be formed to cover at least a region of an upper surface of the first light transmitting layer, and may reflect at least a portion of the light. In addition, the side surface of the first light transmitting layer may include a first inclined surface adjacent to the first reflector and a second inclined surface positioned between the first inclined surface and the substrate.

The first inclined surface and the first reflection surface may be obtuse angles.

The first inclined surface and the second inclined surface may be obtuse angles.

An angle formed by an extension line of the inclined surface of the first reflector with the substrate may be smaller than an angle formed by the first inclined surface and the second inclined surface.

Irregularities may be formed on the side surface of the first light transmitting layer.

The lower surface of the first reflector may be in close contact with the upper surface of the first light transmitting layer.

A side surface of the light emitting device may have a side inclination angle of the light emitting device formed with the upper surface of the substrate. In addition, a side surface of the first light transmitting layer opposite to a side surface of the light emitting device may have a lower angle of the first light transmitting layer formed with the upper surface of the substrate. In this case, the side inclination angle of the light emitting device and the lower angle of the first light transmitting layer may be different from each other.

The upper surface of the first light transmitting layer may include a concave region in a downward direction.

A region of the first light transmitting layer may have a curvature.

A tangent line of the upper surface of the first light transmitting layer may be parallel to the upper surface of the substrate at a center of the first light transmitting layer.

The first reflector may include a convex region in a downward direction corresponding to the concave region of the upper surface of the first light transmitting layer.

The first reflector may have a maximum thickness in a region close to an upper surface of the light emitting device.

The light emitting apparatus may further include a second reflector spaced apart from the light emitting device.

An angle formed by the first inclined surface and an outer surface of the first reflection surface may be greater than an angle formed by the second reflector and the upper surface of the substrate.

The light emitting apparatus may further include a third reflector covering at least a region of the side surface of the first light transmitting layer.

The first light transmitting layer may have at least a region exposed to the outside.

According to an embodiment of the present disclosure, a light emitting apparatus is provided, which includes a substrate, a light emitting device, a first light transmitting layer, a first reflector, and a third reflector. The light emitting device may be disposed on the substrate, and may emit light. The first light transmitting layer may be formed on the substrate to cover at least a surface of the light emitting device, and may be formed of a material that transmits the light. The first reflector may be formed to cover at least a region of an upper surface of the first light transmitting layer, and may reflect at least a portion of the light.

The third reflector may include an inner surface in contact with the first light transmitting layer and an outer surface opposite to the inner surface. An angle of the outer surface of the third reflector may be greater than an angle of the inner surface of the third reflector.

The first light transmitting layer may include a first inclined surface adjacent to the first reflector and a second inclined surface positioned between the first inclined surface and the substrate.

An angle formed by the first inclined surface and the second inclined surface may be greater than an angle formed by the outer surface or the inner surface of the third reflector with the substrate.

The first light transmitting layer may have at least a region exposed to the outside.

Irregularities may be formed on a side surface of the first light transmitting layer.

A side surface of the light emitting device may have a side inclination angle of the light emitting device formed with an upper surface of the substrate.

The upper surface of the first light transmitting layer may include a concave region in a downward direction.

A region of the first light transmitting layer may have a curvature.

A tangent line of the upper surface of the first light transmitting layer may be parallel to the substrate at a center of the first light transmitting layer.

The first reflector may include a convex region in a downward direction corresponding to the concave region of the upper surface of the first light transmitting layer.

The light emitting apparatus may further include a second reflector spaced apart from the light emitting device.

The light emitting apparatus is formed in an inner space of the second reflector to cover the light emitting device, and may further include a second light transmitting layer that transmits the light.

### [Advantageous Effects]

A light emitting apparatus according to an embodiment of the present disclosure may improve side emission and light extraction efficiency through a light transmitting layer and a reflector.

A light emitting apparatus according to an embodiment of the present disclosure may adjust light emitting characteristics, by controlling a light emitting area on a side surface.

A light emitting apparatus according to an embodiment of the present disclosure may improve reliability by delaying moisture penetration into an interior of the light emitting apparatus through increasing a length of a moisture penetration path.

A light emitting apparatus according to an embodiment of the present disclosure may reduce stress due to external pressure and improve structural stability.

A light emitting apparatus according to an embodiment of the present disclosure may prevent discoloration by increasing light stability and increasing resistance to yellowing through using a reflector.

A light emitting apparatus according to an embodiment of the present disclosure may increase an amount of light emitted to the outside by reducing a loss of side light of a light emitting device.

A light emitting apparatus according to an embodiment of the present disclosure ma have high color purity by reducing chromatic aberration of side light of a light emitting device.

### [Description of Drawings]

FIG. 1 is a schematic view illustrating a light emitting apparatus according to a first embodiment of the present disclosure.
FIG. 2 is a graph of radiation characteristics of the light emitting apparatus according to the first embodiment of the present disclosure.
FIG. 3 is a schematic view illustrating a light emitting apparatus according to a second embodiment of the present disclosure.
FIG. 4 is a graph of radiation characteristics of the light emitting apparatus according to the second embodiment of the present disclosure.
FIG. 5 is a schematic view illustrating a light emitting apparatus according to a third embodiment of the present disclosure.
FIG. 6 is a vertical cross-sectional view of a light emitting apparatus according to a fourth embodiment of the present disclosure.
FIG. 7 is a lateral cross-sectional view of the light emitting apparatus according to the fourth embodiment of the present disclosure.
FIG. 8 is a graph of radiation characteristics of the light emitting apparatus according to the fourth embodiment of the present disclosure.
FIG. 9 is a schematic view illustrating a light emitting apparatus according to a fifth embodiment of the present disclosure.
FIG. 10 is a schematic view illustrating a light emitting apparatus according to a sixth embodiment of the present disclosure.
FIG. 11 is a schematic view illustrating a light emitting apparatus according to a seventh embodiment of the present disclosure.
FIG. 12 is a graph of radiation characteristics of the light emitting apparatus according to the seventh embodiment of the present disclosure.
FIG. 13 is a schematic view illustrating a light emitting apparatus according to an eighth embodiment of the present disclosure.
FIG. 14 is a schematic view illustrating a light emitting apparatus according to a ninth embodiment of the present disclosure.
FIG. 15 is a schematic view illustrating a light emitting apparatus according to a 10th embodiment of the present disclosure.
FIG. 16 is a schematic view illustrating a light emitting apparatus according to an 11th embodiment of the present disclosure.
FIG. 17 is a schematic view illustrating a light emitting apparatus according to a 12th embodiment of the present disclosure.
FIG. 18 is a schematic view illustrating a light emitting apparatus according to a 13th embodiment of the present disclosure.
FIG. 19 is a graph of radiation characteristics of the light emitting apparatus according to the 13th embodiment of the present disclosure.
FIG. 20 is a schematic view illustrating a light emitting apparatus according to a 14th embodiment of the present disclosure.
FIG. 21 is a graph of radiation characteristics of the light emitting apparatus according to the 14th embodiment of the present disclosure.
FIG. 22 is a schematic view illustrating a light emitting apparatus according to a 15th embodiment of the present disclosure.
FIG. 23 is a diagram schematically illustrating a lighting apparatus according to an embodiment of the present disclosure.
FIG. 24 is a diagram schematically illustrating a display apparatus according to an embodiment of the present disclosure.

### [Mode for Invention]

In the following description, for the purposes of explanation, numerous specific details are set forth in order to provide a thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as being limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, embodiments of a light emitting apparatus of the present disclosure will be described in detail with the accompanying drawings.

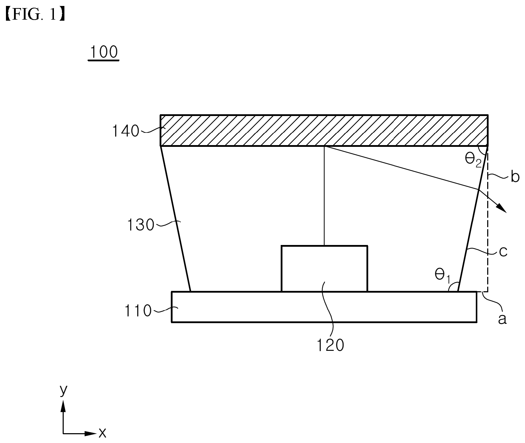

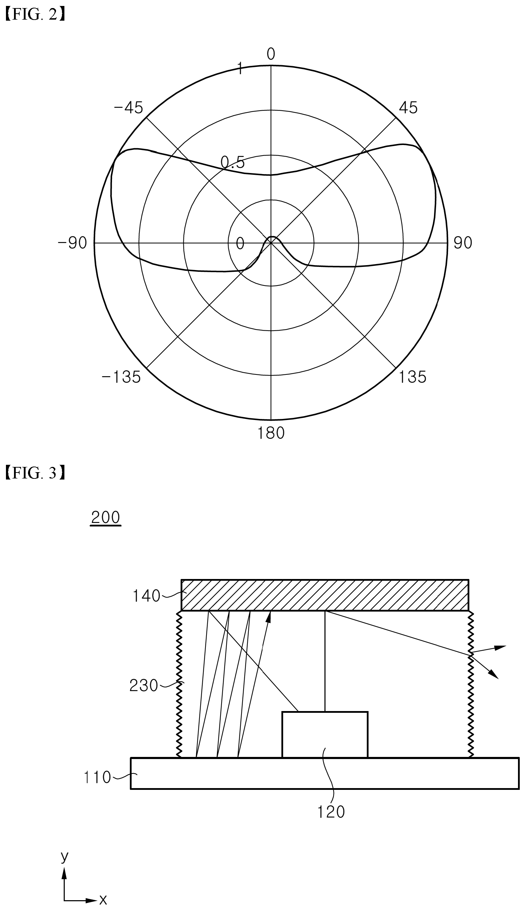

FIGS. 1 and 2 are diagrams illustrating a light emitting apparatus according to a first embodiment of the present disclosure.

FIG. 1 is a schematic view illustrating a light emitting apparatus 100 according to the first embodiment of the present disclosure.

Referring to FIG. 1, the light emitting apparatus 100 according to the first embodiment includes a substrate 110, a light emitting device 120, a light transmitting layer 130 and a reflector 140.

The substrate 110 may include interconnections electrically connected to the light emitting device 120. The interconnections of the substrate 110 may transmit power for an operation of the light emitting device 120 to the light emitting device 120. For example, the substrate 110 may be a printed circuit board including a base and interconnections insulated from the base. For example, the base may be formed of various materials such as be phenol, epoxy, AlN (Aluminum nitride) ceramic, Al₂O₃ ceramic, polymer, ABS (Acrylonitrile butadiene styrene), LCP (Liquid crystalline polymer), PI (Polyamide), PPS (Polyphenylene sulfide), TPE (Thermoplastic elastomer), metal, or the like. In addition, a thermal conductivity of the substrate 110 may be about 170 W/(m·K).

In addition, a reflection layer formed of a material that reflects light may be further formed on an upper surface of the substrate 110. For example, the reflection layer may be formed of a metal such as Cu, Ag, Au, Al. Further, the reflection layer may be formed of an oxide such as TiO₂, BaSO₄, or Al₂O₃. Furthermore, the reflection layer may be formed of any material that can reflect light, even when it is not a metal or an oxide.

The light emitting device 120 is mounted on the substrate 110, and may emit light by receiving power through the interconnections of the substrate 110.

The light emitting device 120 may include a semiconductor structure including an n-type semiconductor layer, an active layer, and a p-type semiconductor layer. The n-type semiconductor layer may be a conductive semiconductor layer including an n-type impurity, and the p-type semiconductor layer may be a conductive semiconductor layer including a p-type impurity. In addition, the active layer is interposed between the n-type semiconductor layer and the p-type semiconductor layer, and may include a multi-quantum well structure (MQW). For example, the light emitting device 120 may be a light emitting diode chip including a semiconductor structure.

In FIG. 1, a y-axis direction is a direction in which semiconductor layers are stacked or an upward direction, and an x-axis direction is a side direction perpendicular to the y-axis.

The light transmitting layer 130 may be formed over the substrate 110 to cover the light emitting device 120. In addition, the light transmitting layer 130 may be formed of a light-transmitting material that transmits light. For example, the light transmitting layer 130 may be formed of a light-transmitting resin, such as epoxy resin, silicone resin, fluorine resin, or the like. In addition, the light transmitting layer 130 may be formed of light-transmitting glass, such as borosilicate glass, aluminum silicate glass, silicate glass, synthetic quartz glass, or the like. In addition, the light transmitting layer 130 may be formed of a ceramic that transmits light. Accordingly, the light transmitting layer 130 may provide a path through which light is transmitted and progressed.

The light transmitting layer 130 may play a role as an optical lens that refracts light emitted from the light emitting device 120 to adjust a viewing angle. In addition, the light transmitting layer 130 may cover the light emitting device 120 to play a role as protecting the light emitting device 120 from external environments, such as dust, moisture, impact, or others.

The reflector 140 is disposed on the light transmitting layer 130. For example, the reflector 140 may be disposed to cover an entire upper surface of the light transmitting layer 130. However, a structure in which the reflector 140 is disposed is not limited thereto. The reflector 140 may be disposed to cover only a region of an upper region of the light transmitting layer 130 according to a light-emitting pattern of the light emitting apparatus 100.

The reflector 140 may be formed of a material that reflects light. The reflector 140 may reflect at least a portion of light emitted from the light emitting device 120. In more detail, the reflector 140 may reflect all or a portion of light that moves inside the light transmitting layer 130 and reaches the reflector 140. For example, the reflector 140 may be formed of a metal, such as Ag, Al, Pt, Au, or the like. Alternatively, the reflector 140 may be formed of epoxy resin, silicone resin, glass, or ceramic in which a light reflective material is dispersed. For example, the light reflective material may be anything that can reflect light, such as TiO₂, Ba₂Ti₉O₂₀, BaSO₄, SiO₂, CaCO₃, ZnO, or CaCO₃. Alternatively, the reflector 140 may be a distributed Bragg reflector (DBR) formed by stacking a plurality of layers in which at least one thereof has a different refractive index. Alternatively, the reflector 140 may be an omni-directional reflector. Alternatively, the reflector 140 may be formed by including a plurality of the above-described reflectors 140.

According to the embodiment of the present disclosure, a portion of light emitted from the light emitting device 120 may be directed toward the reflector 140, and another portion thereof may be emitted to the outside of the light emitting apparatus 100 through a side surface of the light transmitting layer 130. A portion or all of light directed toward the reflector 140 may be reflected from the reflector 140 and directed toward the side surface of the light transmitting layer 130. According to an embodiment, light emitted from the light emitting device 120 may be emitted from at least a surface of the surfaces of the light transmitting layer 130 that is spaced apart from the reflector 140. That is, a main emitting surface of the light emitting apparatus 100 may be the surfaces of the light transmitting layer 130 spaced apart from the reflector 140. Accordingly, the light emitting apparatus 100 of the present embodiment may emit most or all of light emitted from the light emitting device 120 to the outside through the side surface of the light transmitting layer 130. In addition, a main emitting surface of the light emitting apparatus 100 of the present embodiment may be the side surface of the light transmitting layer 130. That is, the light emitting apparatus 100 of the present embodiment may have a higher luminous intensity on the side surface, which is the main emitting surface, than a luminous intensity on an upper surface or a lower surface.

The light emitting apparatus 100 of the present embodiment may have the side surface of the light transmitting layer 130, which is the main emitting surface, formed as an inclined surface. Referring to FIG. 1, a lower angle θ₁ formed by the side surface of the light transmitting layer 130 and a lower surface of the light transmitting layer 130 or the upper surface of the substrate 110 may be an obtuse angle. That is, the lower angle θ₁ of the light transmitting layer 130 may be greater than 90 degrees. Furthermore, the lower angle θ₁ of the light transmitting layer 130 may be more than 90 degrees and 120 degrees or less. As such, when the lower angle θ₁ of the light transmitting layer 130 is the obtuse angle, a main light exiting path may be directed to the side surface and a downward direction. In this case, the light emitting apparatus 100 may have wide radiation characteristics.

In addition, an upper angle θ₂ formed by the side region of the light transmitting layer 130 and an upper region of the light transmitting layer 130 or the lower surface of the reflector 140 may be an acute angle. Furthermore, the upper angle θ₂ of the light transmitting layer 130 may be 60 degrees or more and less than 90 degrees. In the present embodiment, the lower angle θ₁ and the upper angle θ₂ of the light transmitting layer 130 and may be an internal angle of the light transmitting layer 130.

In addition, a right triangle may be formed by a hypotenuse c formed of the side surface of the light transmitting layer 130, a base a extended from the lower surface of the light transmitting layer 130 or the upper surface of the substrate 110, and a height b extending vertically from the base a and contacting an end of the hypotenuse c. Herein, a length of the base a may be less than the height b. For example, a ratio of the length of the height b to the length of the base a may be greater than 1.73. In addition, the length of the base a may be less than a length of the hypotenuse c. For example, a ratio of the length of the hypotenuse c to the length of the base a may be less than 0.5.

In addition, a side surface of the light emitting device 120 may have an inclination. A side inclination angle of a side surface of the light emitting device 120 and the lower angle θ₁ of a side surface of the light transmitting layer 130 opposite to the side surface of the light emitting device 120 may have different angles. Herein, the side inclination angle of the light emitting device 120 may be an internal angle of the light emitting device 120 formed by a side surface of the light emitting device 120 and the upper surface of the substrate 110 or the lower surface of the light emitting device 120. As an example, the side inclination angle of the light emitting device 120 may be smaller than the lower angle θ₁ of the light transmitting layer 130. In this case, light emitted from a side surface of the light emitting device 120 may be efficiently emitted to a side surface of the light emitting apparatus 100. As another example, the side inclination angle of the light emitting device 120 may be larger than the lower angle θ₁ of the light transmitting layer 130. In this case, light emitted from the side surface of the light emitting device 120 may be efficiently emitted to a lower surface of the light emitting apparatus 100, thereby widening a viewing angle of the light emitting apparatus 100.

In addition, the light transmitting layer 130 may be thicker than the light emitting device 120, the reflector 140, or the substrate 110. In this case, a sufficient optical path may be secured until light emitted from the light emitting device 120 and light reflected from the reflector 140 move to the side surface of the light transmitting layer 130, thereby improving a side light extraction efficiency of the light emitting apparatus 100.

At least a portion of light emitted from the light emitting device 120 and directed in the upward direction may be reflected from the reflector 140 and directed to the side surface.

In this case, when the side surface of the light transmitting layer 130 is a plane perpendicular to the lower surface, a portion of light may be total-internally reflected from the side surface, and may be directed toward an inner side of the light transmitting layer 130. A portion of the light reflected from the side surface of the light transmitting layer 130 and directed toward the inner side of the light transmitting layer 130 may be absorbed by the substrate 110, or reabsorbed by the light emitting device 120 and lost. In addition, another portion of light reflected from the side surface of the light transmitting layer 130 and directed toward the inner side of the light transmitting layer 130 may be absorbed by a boundary surface of the light transmitting layer 130 and components inside the light transmitting layer 130, or may be lost due to continuous reflection.

Accordingly, the light emitting apparatus 100 according to the present embodiment may reduce an amount of light that is total-internally reflected from the side surface of the light transmitting layer 130, by forming the side surface of the light transmitting layer 130, which is the main emitting surface, as the inclined surface. Accordingly, the light emitting apparatus 100 of the present embodiment may improve the light extraction efficiency by forming the side surface of the light transmitting layer 130 to have an inclination, and further may improve side emission efficiency by increasing an amount of light emitted to a direction of the side surface and the downward direction.

FIG. 2 is a graph of radiation characteristics of the light emitting apparatus 100 according to the first embodiment of the present disclosure.

The radiation characteristics represent a distribution of luminous intensity emitted from a light source such as the light emitting apparatus of the present disclosure. That is, it is possible to check a directivity of the light source and the luminous intensity according to an angle or direction through the radiation characteristics. In the present embodiment, a y-axis of the radiation characteristics may be a relative illuminance according to the angle of the light source, and an x-axis may be a radiation angle based on a direct point of the light source. Herein, the relative illuminance may be expressed based on a highest luminous intensity.

Referring to FIG. 2, it can be seen that the light emitting apparatus 100 according to the first embodiment emits most of light in a direction of 45 to 90 degrees and -45 to -90 degrees rather than 45 to -45 degrees. Furthermore, when a region where the relative illuminance is 0.5 or more is referred to as a main exiting angle, a main exiting angle of the light emitting apparatus 100 of the present embodiment may be between -50 degrees and -100 degrees and between 50 degrees and 100 degrees. That is, the light emitting apparatus 100 of the present embodiment has a high luminous intensity between 50 degrees and 100 degrees and between -50 degrees and -100 degrees. That is, the light emitting apparatus 100 according to the first embodiment emits most of light in the side direction rather than the upward direction.

That is, it can be confirmed that the light emitting apparatus 100 according to the first embodiment has a relatively lower luminous intensity of front light in the y-axis direction than that of side light in the x-axis direction. Furthermore, the light emitting apparatus 100 according to the first embodiment may have an illuminance or a luminance intensity of less than 50% at a radiation angle of 0 degrees, but may have a luminance intensity of 50% or more at a radiation angle of 45 degrees or more or -45 degrees or less.

In addition, referring to FIG. 2, the light emitting apparatus 100 according to the first embodiment may have a low luminous intensity even at a radiation angle of -90 degrees or less or 90 degrees or more. For example, the light emitting apparatus 100 may have a luminous intensity of 10% or more at the radiation angle of -90 degrees or less or 90 degrees or more. This confirms that the light emitting apparatus 100 of the present embodiment may emit light even in directions of 90 degrees or more and -90 degrees or less while improving the side light extraction efficiency.

In the description of various embodiments of the present disclosure described hereinafter, a same configuration as that of the previously described embodiments is omitted or briefly described. Accordingly, for a detailed description of the omitted or briefly described configuration, refer to the description of the previous embodiment.

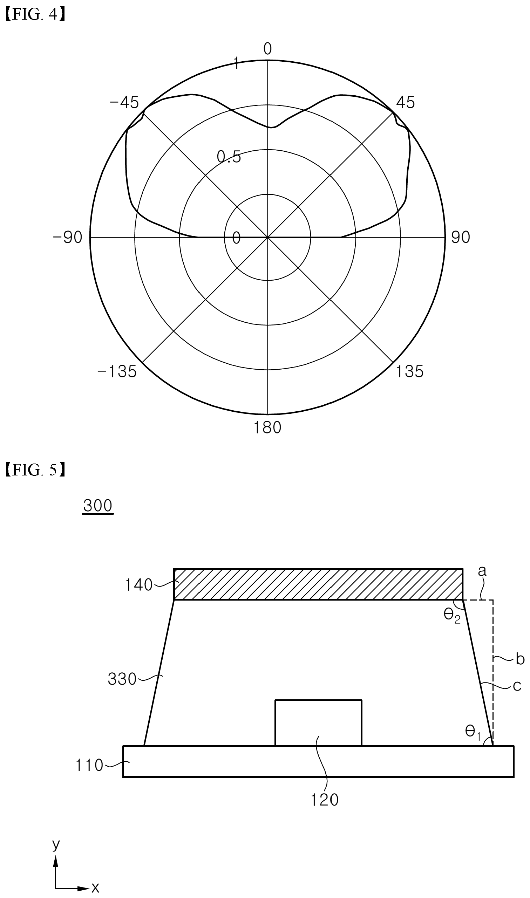

FIG. 3 is a schematic view of a light emitting apparatus according to a second embodiment, and FIG. 4 is a graph of radiation characteristics of the light emitting apparatus according to the second embodiment of FIG. 3.

A light emitting apparatus 200 of FIG. 3 includes a substrate 110, a light emitting device 120 disposed on the substrate 110, a light transmitting layer 230 disposed to cover the light emitting device 120 and a reflector 140 formed to cover an upper surface of the light transmitting layer 230. In this case, the light emitting apparatus 200 may have irregularities formed on at least a region of a side surface of the light transmitting layer 230.

In the light emitting apparatus 200 of the present embodiment, light emitted in an upward direction from the light emitting device 120 may be reflected by the reflector 140 and emitted to the outside through the side surface of the light transmitting layer 230. In this case, the irregularities may reduce a total internal reflection of light by diversifying an incident angle of light on the side surface of the light transmitting layer 230, thereby improving a light extraction efficiency on the side surface of the light transmitting layer 230.

A difference between a maximum height and a minimum height of the irregularities may be smaller than a thickness of the reflector 140. In addition, the difference between the maximum height and the minimum height of the irregularities may be smaller than a height of the light emitting device 120. The irregularities may be formed to a designed size through a mold-and-injection process of the light transmitting layer 230, or may be formed through a dicing process. In addition, when the light transmitting layer 230 includes a filler, such as a reflective material, a wavelength conversion material, a light diffuser, or the like, the irregularities may be formed on the side surface of the light transmitting layer 230 by the filler. In this case, the light transmitting layer 230 may emit light at one or more angles by the irregularities of the light transmitting layer 230. That is, an inclination of an emitting surface of a region of the light transmitting layer 230 may be different from that of an emitting surface of the other region adjacent thereto.

Referring to FIG. 4, it can be seen that the light emitting apparatus (200 in FIG. 3) according to the second embodiment emits most of light in a direction of about 30 degrees to about 60 degrees and about -30 degrees to -60 degrees.

Referring to FIG. 4, when a radiation angle is 0 degrees, a luminous intensity of the light emitting apparatus (200 in FIG. 3) may be less than 80%. That is, a luminous intensity in a region perpendicular to the light emitting device (120 in FIG. 3) may have a luminous intensity of 80% relative to a maximum luminous intensity. Herein, the region perpendicular to the light emitting device (120 in FIG. 3) is a region positioned in a vertical direction with respect to a center of a horizontal cross-section of the light emitting device (120 in FIG. 3). In addition, a luminous intensity when the radiation angle is 30 degrees to 60 degrees and -30 degrees to -60 degrees may be higher than a luminous intensity when the radiation angle is 0 degrees. As such, the light emitting apparatus (200 in FIG. 3) emits more light in a side direction than in the upward direction.

In addition, looking at the radiation characteristics of FIG. 4, radiation characteristics of a region corresponding to light emitted from a side surface of the light emitting apparatus (200 of FIG. 3) may have a shape including a plurality of peaks and valleys. That is, it can be seen that a plurality of regions where a relative illuminance is close to 1 is included due to the irregularities of the light transmitting layer 230, and through this, an amount of light emitted through the side surface of the light emitting apparatus (200 in FIG. 3) increases.

FIG. 5 is a schematic view illustrating a light emitting apparatus according to a third embodiment of the present disclosure.

A light emitting apparatus 300 according to the third embodiment of the present disclosure includes a substrate 110, a light emitting device 120, a light transmitting layer 330 and a reflector 140. The substrate 110, the light emitting device 120, and the reflector 140 of the light emitting apparatus 300 of the third embodiment are identical to the substrate 110, the light emitting device 120 and the reflector 140 of the light emitting apparatus (100 of FIG. 1) of the first embodiment. However, a structure of the light transmitting layer 330 of the light emitting apparatus 300 in the third embodiment is different from that of the light transmitting layer 130 of the light emitting apparatus (100 of FIG. 1) in the first embodiment.

In the present embodiment, the light transmitting layer 330 has a side surface, which is a main emitting surface of the light emitting apparatus 300, is formed as an inclined surface. Referring to FIG. 5, a lower angle θ₁ of the light transmitting layer 330 may be an acute angle. For example, the lower angle θ₁ of the light transmitting layer 330 may be 60 degrees or more and less than 90 degrees. In addition, an upper angle θ₂ of the light transmitting layer 330 may be an obtuse angle. For example, the upper angle θ₂ of the light transmitting layer 330 may be more than 90 degrees and 120 degrees or less.

In a right triangle formed by a hypotenuse c corresponding to the side surface of the light transmitting layer 330, a base a extended from an upper surface of the light transmitting layer 330 or a lower surface of the reflector 140 and a height b of the light transmitting layer 330, a length of the base a may be smaller than a height b. In this case, a ratio of the length of the height b and the base a may be 1.73 or more. In addition, the length of the base a may be less than a length of the hypotenuse c. In addition, a ratio of the length of the hypotenuse c to the length of the base a may be less than 0.5.

In addition, a side surface of the light emitting device 120 may have an inclination. A side inclination angle of a side surface of the light emitting device 120 and the lower angle θ₁ of a side surface of the light transmitting layer 330 opposite to the side surface of the light emitting device 120 may have different angles. Herein, the side inclination angle of the light emitting device 120 may be an internal angle of the light emitting device 120 formed by a side surface of the light emitting device 120 and an upper surface of the substrate 110 or a lower surface of the light emitting device 120. By adjusting the angles of the side inclination angle of a side surface of the light emitting device 120 and the lower angle θ₁ of a side surface of the light transmitting layer 330, a viewing angle of the light emitting apparatus 300 may be adjusted. As an example, the side inclination angle of the light emitting device 120 may be smaller than the lower angle θ₁ of the light transmitting layer 330. In this case, light emitted from a side surface of the light emitting device 120 may be efficiently emitted to a side surface of the light emitting apparatus 300. As another example, the side inclination angle of the light emitting device 120 may be larger than the lower angle θ₁ of the light transmitting layer 330. In this case, light emitted from the side surface of the light emitting device 120 may be efficiently emitted to a lower surface of the light emitting apparatus 300, thereby widening the viewing angle of the light emitting apparatus 300.

In addition, the light transmitting layer 330 may be thicker than the light emitting device 120, the reflector 140, or the substrate 110. At least a portion of light emitted from the light emitting device 120 and directed in an upward direction may be reflected by the reflector 140 and directed to the side surface. In this case, the side surface of the light transmitting layer 330 may be formed to have an inclination, thereby reducing a total internal reflection of light on the side surface of the light transmitting layer 330. Accordingly, the light emitting apparatus 300 of the present embodiment may improve a light extraction efficiency from the side surface of the light emitting apparatus 300 by forming the side surface of the light transmitting layer 330 to have the inclination.

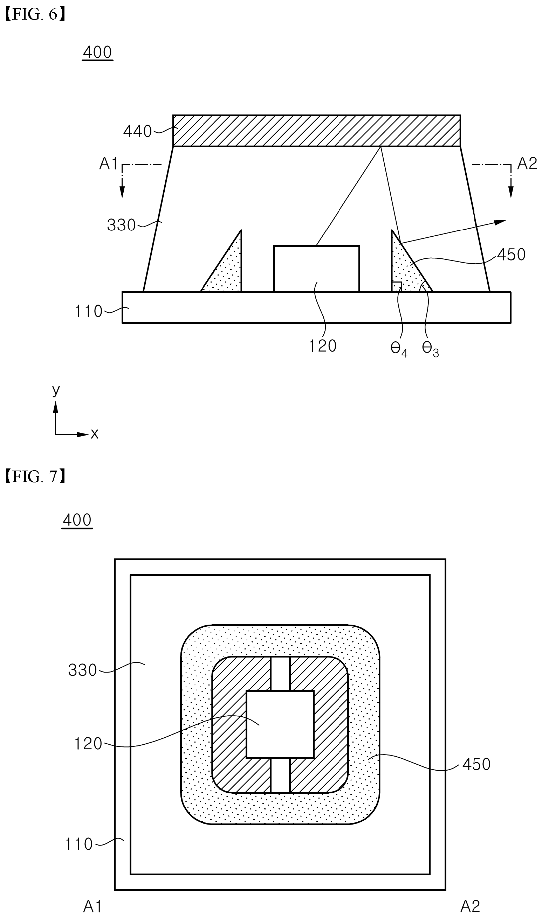

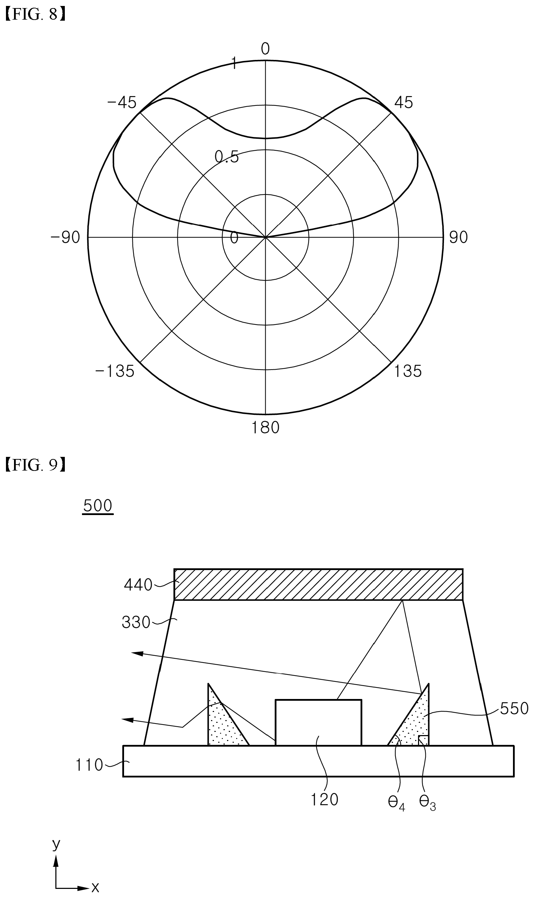

FIGS. 6 and 8 are diagrams illustrating a light emitting apparatus according to a fourth embodiment of the present disclosure. FIG. 6 is a vertical cross-sectional view of a light emitting apparatus 400 according to the fourth embodiment of the present disclosure, and FIG. 7 is a lateral cross-sectional view of the light emitting apparatus 400 according to the fourth embodiment of the present disclosure. In addition, the sectional view taken along the A1-A2 direction in FIG. 7 is shown in one of FIGS. 1, 3, 5, 6, 9, 10, 11, 13-18, 20, or 22. For example, the sectional view taken along A1-A2 in Figure 6 is shown in Figure 7.

The light emitting apparatus 400 according to the fourth embodiment of the present disclosure includes a substrate 110, a light emitting device 120, a light transmitting layer 330, a first reflector 440 and a second reflector 450. Herein, the substrate 110, the light emitting device 120, the light transmitting layer 330, and the first reflector 440 of the light emitting apparatus 400 of the fourth embodiment are identical to the substrate 110, the light emitting device 120, the light transmitting layer 330 and the reflector 140 of the light emitting apparatus (300 of FIG. 5) of the third embodiment, respectively.

Referring to FIGS. 6 and 7, the second reflector 450 of the present embodiment is formed on the substrate 110, and is formed to surround the light emitting device 120. That is, the light emitting device 120 is disposed in an inner space of the second reflector 450, and is spaced apart from an inner surface of the second reflector 450.

In this case, an angle formed by an upper surface of the second reflector 450 and an optical axis of a center of the light emitting device 120 may be smaller than an angle at which a luminous intensity of radiation characteristics of the light emitting device 120 is 50% or less, or a beam angle when an illuminance is 50%. In addition, the second reflector 450 may also be spaced apart from the first reflector 440. Such a second reflector 450 may adjust a light path such that light emitted from the light emitting device 120 and light reflected from the first reflector 440 are emitted to the outside of the light emitting apparatus 400 through a side surface of the light transmitting layer 330.

In addition, in FIG. 7, the second reflector 450 may be formed in a quadrangular shape with curved edges in cross section view. Since the second reflector 450 has a gently changing angle of the edge, it may reduce a phenomenon of light being trapped and lost at the edge region, thereby improving a light extraction efficiency of the light emitting apparatus 400. In the present embodiment, the second reflector 450 is not limited to the quadrangular shape with the curved edges in a cross-section view, and the second reflector 450 may be formed to have various cross-sectional shapes.

In addition, referring to FIG. 6, the second reflector 450 may be formed to have a height greater than that of the light emitting device 120. Accordingly, the second reflector 450 may reflect light from the outside of the second reflector 450 toward the light emitting device 120, thereby reducing light re-incident into the light emitting device 120. However, the structure of the second reflector 450 is not limited thereto, and the second reflector 450 may be formed to have the height equal to that of the light emitting device 120 or lower than that of the light emitting device 120.

The second reflector 450 may be formed of a material that reflects at least a portion of light moving the inside of the light transmitting layer 330. For example, the second reflector 450 may have a light reflectivity of 70% or more.

The second reflector 450 may be formed of metal. Furthermore, the second reflector 450 may be formed of a metal having a reflectivity of 70% or more for light of a specific wavelength, such as Al, Cu, Fe, Ag, Au, or the like.

Alternatively, the second reflector 450 may include a base and a light reflective material dispersed in the base. For example, the base may be formed of epoxy resin, silicone resin, glass or ceramic. In addition, the light reflective material dispersed in the base may be at least one of TiO₂, Ba₂Ti₉O₂₀, BaSO₄, SiO₂, CaCO₃, ZnO, or CaCO₃.

Alternatively, the second reflector 450 may be a distributed Bragg reflector (DBR) formed by stacking a plurality of layers in which at least one thereof has a different refractive index. Alternatively, the second reflector 450 may be an omni-directional reflector. Alternatively, the second reflector 450 may be formed to include a plurality of types among the second reflectors described above.

Referring to FIG. 6, the second reflector 450 may have the inner surface formed as a plane perpendicular to a lower surface thereof, and an outer surface formed as an inclined surface forming an acute angle with the lower surface. Alternatively, the inner surface of the second reflector 450 may also be formed as an inclined surface. An angle θ₃ formed by the lower surface and the outer surface of the second reflector 450 and an angle θ₄ formed by the inner surface and the lower surface may be different from each other. Through this, the second reflector 450 may transmit light incident on the inner surface, and reflect light incident on the outer surface. As an example, an angle θ₃ formed by the lower surface and the outer surface of the second reflector 450 may be smaller than an angle θ₄ formed by the inner surface and the lower surface.

As illustrated in FIG. 6, the angle θ₃ formed by the lower surface and the outer surface of the second reflector 450 may be smaller than the lower angle θ₁ of the light transmitting layer 330. Herein, the lower angle θ₁ of the light transmitting layer 330 may be an internal angle formed by the side surface of the light transmitting layer 330 and the upper surface of the substrate 110 or the lower surface of the light transmitting layer 330, as illustrated in FIG. 5. At least a portion of light that is reflected or refracted from an interface of the first reflector 440 or the light transmitting layer 330 and directed in a downward direction may be reflected from an inclined outer surface of the second reflector 450 to the side surface of the light transmitting layer 330 to be emitted to the outside of the light emitting apparatus 400.

In addition, the second reflector 450 may reflect a portion of light and transmit another portion of light. A light transmittance rate of the second reflector 450 may be adjusted by adjusting a ratio of light reflective material dispersed in the second reflector 450. To maintain a certain level of transmittance, an amount of light reflective material in the second reflector 450 may be less than that of the base. That is, a ratio of an atomic percentage of a main component material of the light reflective material to a main component material of the base may be less than 1. The ratios of the main component materials may be obtained as an atomic percentage by analyzing the second reflector 450 using a SEM-EDX (Scanning Electron Microscope-Energy Dispersive X-ray Spectrometer). In this case, the atomic percentage of the main component material of the base and the atomic percentage of the main component material of the light reflective material may be 10% to 35%. For example, when the base material is silicon and the light reflective material is TiO₂, an atomic percentage of Si, which is the main component material of the base material of the second reflector 450, may be 25%, and an atomic percentage of Ti, which is the main component material of the light reflective material, may be 5%.

A thickness of an upper region of the second reflector 450 may be smaller than that of a lower region of the second reflector 450. In this case, a transmittance rate of the upper region of the second reflector 450 may be increased compared to that of the lower region. The light emitting apparatus 400 may increase a luminous intensity emitted to a side surface of the upper region positioned high through the second reflector 450 in which its light transmittance increases as it is farther from the lower surface of the second reflector 450 in a vertical direction.

According to this embodiment of the present disclosure, the second reflector 450 may have a light transmittance rate higher than that of the first reflector 440, and through this, the light emitting apparatus 400 may relatively increase the luminous intensity emitted to the side surface compared to the luminous intensity emitted to the upper surface. However, the light emitting apparatus of the present disclosure is not limited thereto, and the first reflector 440 and the second reflector 450 may have a same light transmittance rate, or may have a light transmittance rate different from each other. The light emitting apparatus 400 may increase light uniformity by adjusting the light transmittance rates of the first reflector 440 and the second reflector 450.

The second reflector 450 of the light emitting apparatus 400 of the present embodiment may reflect light reflected or refracted from the interface of the first reflector 440 or the light transmitting layer 330 and directed in a downward direction to be directed toward the side surface of the light transmitting layer 330. Accordingly, by the second reflector 450, the light emitting apparatus 400 of the present embodiment may prevent light from being lost due to being trapped inside the light transmitting layer 330 or from being lost due to being absorbed by the substrate 110 or the light emitting device 120.

Features of the first reflector 440 and the second reflector 450 described above may be equally applied to other embodiments.

FIG. 8 is a graph of radiation characteristics of the light emitting apparatus (400 of FIGS. 6 and 7) according to the fourth embodiment of the present disclosure.

Referring to the radiation characteristics of FIG. 8, the radiation characteristics exists -90 degrees or more and 90 degrees or less.

Compared with the radiation characteristics of the light emitting apparatus (100 of FIG. 1) of the first embodiment of FIG. 2, the light emitting apparatus (400 of FIGS. 6 and 7) of the fourth embodiment has a luminous intensity emitted along a vertical center line similar to that of the light emitting apparatus (100 of FIG. 1) of the first embodiment, but an amount of light emitted in the downward direction is reduced.

That is, the light emitting apparatus (400 of FIGS. 6 and 7) according to the fourth embodiment may prevent light from being emitted in the downward direction of the light emitting apparatus 400 by at least one of a structure of the light transmitting layer 330 or the second reflector 350, and further, may emit light proceeding in the downward direction to a side direction through a main emitting surface. In other words, the light emitting apparatus (400 of FIGS. 6 and 7) according to the fourth embodiment may increase the luminous intensity emitted in the side direction.

For example, the second reflector 450 may change a path of light emitted from the light emitting device 120 at an angle of 85 degrees or more and -85 degrees or less, and thus, may help ensure that a main exiting angle of the light emitting apparatus 400 becomes -85 degrees or more and 85 degrees or less. Furthermore, the second reflector 450 may change the path of light emitted from the light emitting device 120 at an angle of 60 degrees or more and -60 degrees or less, thereby making the main exiting angle of the light emitting apparatus 400 be -60 degrees or more and 60 degrees or less. That is, the second reflector 450 reflects light emitted from the light emitting device 120 in a direction of -60 degrees or less and 60 degrees or more to a direction of -60 degrees to 60 degrees, and thus, the light emitting apparatus 400 of the present embodiment may have a luminous intensity at -60 degrees to 60 degrees higher than a luminous intensity at -60 degrees or less and 60 degrees or more.

FIG. 9 is a schematic view illustrating a light emitting apparatus according to a fifth embodiment of the present disclosure.

The light emitting apparatus 500 according to the fifth embodiment includes a substrate 110, a light emitting device 120, a light transmitting layer 330, a first reflector 440, and a second reflector 550. The light emitting apparatus 500 according to the fifth embodiment is the same as the light emitting apparatus (400 of FIG. 6) of the fourth embodiment in that it includes the substrate 110, the light emitting device 120, the light transmitting layer 330, and the first reflector 440. However, a structure of the second reflector 550 of the present embodiment is different from that of the second reflector 450 of the fourth embodiment.

Referring to FIG. 9, the second reflector 550 of the light emitting apparatus 500 of the fifth embodiment may have an inner surface formed as an inclined surface forming an acute angle with a lower surface, and an outer surface formed as a plane perpendicular to the lower surface. Alternatively, the outer surface of the second reflector 550 may also be formed as an inclined surface. Herein, an inner surface angle θ₄ which is an angle formed by the inner surface and the lower surface of the second reflector 550 may be smaller than an outer surface angle θ₃ formed by the outer surface and the lower surface. In this case, the inner surface angle θ₄ of the second reflector 550 may be 45 degrees or more and less than 90 degrees. In addition, a difference between the inner surface angle θ₄ and the outer surface angle θ₃ may be 5 degrees or more.

The angle θ₃ formed by the lower surface and the outer surface of the second reflector 450 may be larger than the lower angle θ₁ of the light transmitting layer 330. In this case, the second reflector 450 may emit light, which has passed through the inside, from the outer surface to the side surface of the light transmitting layer 330.

As illustrated in FIG. 9, at least a portion of light reflected or refracted from an interface of the first reflector 440 or the light transmitting layer 330 and directed in a downward direction may be reflected from the inclined inner surface of the second reflector 550 to a side surface of the light transmitting layer 330 to be emitted to the outside of the light emitting apparatus 500. In addition, a portion of light emitted from a side surface of the light emitting device 120 may also be reflected by the second reflector 550 toward an upward direction or a side direction of the light transmitting layer 330. In addition, light total-internally reflected by the light transmitting layer 330 may be re-reflected from the outer surface of the second reflector 550 and passed through the side surface of the light transmitting layer 330, thereby increasing an amount of side light of the light emitting apparatus 500.

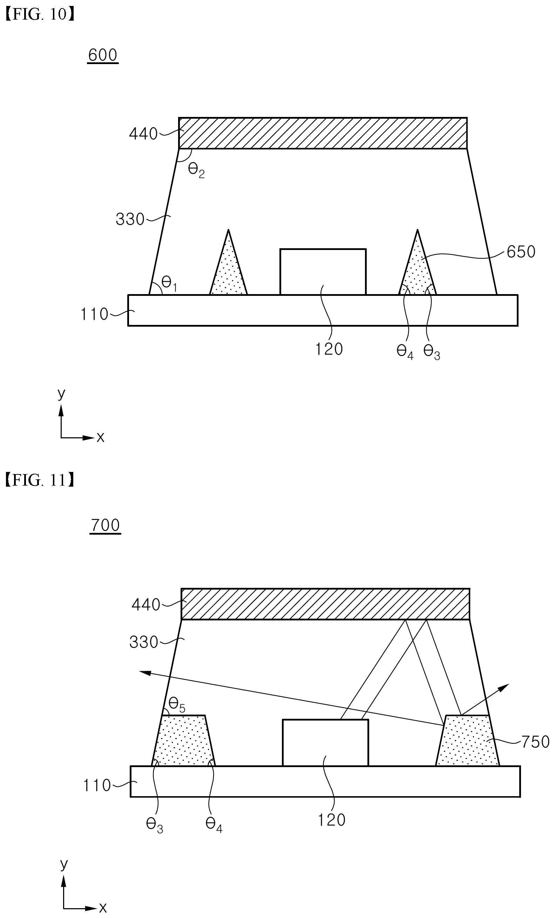

FIG. 10 is a schematic view illustrating a light emitting apparatus according to a sixth embodiment of the present disclosure.

A light emitting apparatus 600 according to the sixth embodiment of the present disclosure includes a substrate 110, a light emitting device 120, a light transmitting layer 330, a first reflector 440, and a second reflector 650. The light emitting apparatus 600 according to the sixth embodiment is the same as the light emitting apparatus (400 of FIG. 6) of the fourth embodiment in that it includes the substrate 110, the light emitting device 120, the light transmitting layer 330, and the first reflector 440. However, a structure of the second reflector 650 of the present embodiment is different from that of the second reflector 450 of the fourth embodiment.

Referring to FIG. 10, the second reflector 650 of the light emitting apparatus 600 of the sixth embodiment has both an inner surface and an outer surface formed as an inclined surface, and an inner surface angle θ₄ and an outer surface angle θ₃ are acute angles. In this case, the inner surface angle θ₄ and the outer surface angle θ₃ may be 45 degrees or more and less than 90 degrees. In addition, the inner surface angle θ₄ and the outer surface angle θ₃ may be identical or different.

The second reflector 650 of this structure may reflect light from both the inner surface and the outer surface toward a side surface of the light transmitting layer 130. That is, the light emitting apparatus 600 of the sixth embodiment may have all effects of the second reflectors 450 and 550 of the light emitting apparatuses (400 of FIG. 6 and 500 of FIG. 9) of the third and fourth embodiments, respectively.

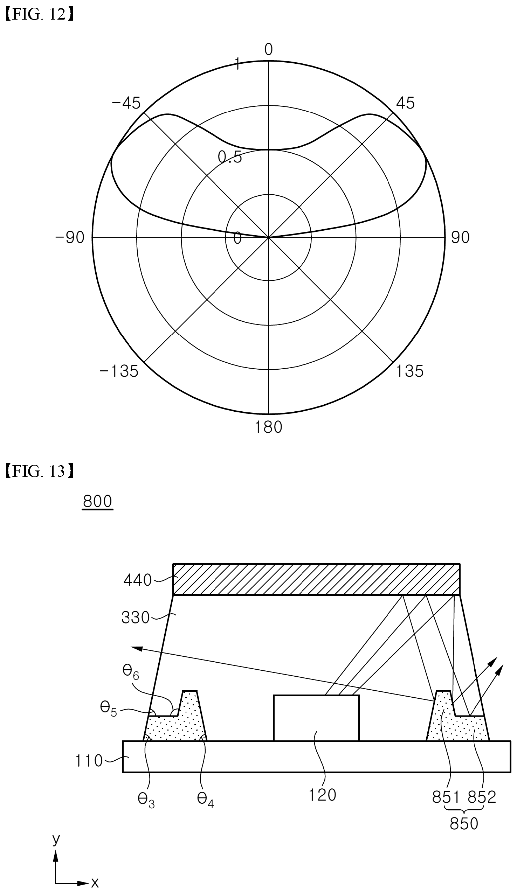

FIGS. 11 and 12 are diagrams illustrating a light emitting apparatus according to a seventh embodiment of the present disclosure. In addition, FIG. 13 is a schematic view illustrating a light emitting apparatus according to an eighth embodiment of the present disclosure.

FIG. 11 is a schematic view illustrating a light emitting apparatus 700 according to the seventh embodiment of the present disclosure, and FIG. 13 is a schematic view illustrating a light emitting apparatus 800 according to the eighth embodiment of the present disclosure.

The light emitting apparatuses 700 and 800 according to the seventh and eighth embodiments, respectively, include a substrate 110, a light emitting device 120, a light transmitting layer 330, a first reflector 440, and second reflectors 750 and 850, respectively. The light emitting apparatuses 700 and 800 according to the seventh and eighth embodiments are the same as the light emitting apparatus (400 of FIG. 6) of the fourth embodiment in that they include the substrate 110, the light emitting device 120, the light transmitting layer 330, and the first reflector 440. However, the structures of the second reflectors 750 and 850 of the seventh and eighth embodiments, respectively, are different from that of the second reflector 450 of the fourth embodiment.

Referring to FIGS. 11 and 13, the second reflectors 750 and 850 of the light emitting apparatuses 700 and 800 according to the seventh and eighth embodiments have different structures, but both include a flat upper surface. When the second reflectors 750 and 850 include the flat upper surface, a contact area with the light transmitting layer 330 may be increased compared to the second reflector having no upper surface as in the previous embodiment. Accordingly, the second reflectors 750 and 850 including the flat upper surface may improve an adhesion with the light transmitting layer 330 and reduce a phenomenon of the light transmitting layer 330 being peeled off.

As shown in FIG. 11 and FIG. 13, a region of the second reflector 750 or 850 may have a region parallel to a region of the first reflector 440. In this case, light reflected from the first reflector 440 and directed downward may be reflected from an upper surface of the second reflector 750 or 850, and emitted to the outside of the light emitting apparatus 700 or 800 through a side surface of the light transmitting layer 330.

In addition, in the present embodiments, the second reflectors 750 and 850 may have an inner surface as an inclined surface that forms an acute angle with a lower surface thereof. Accordingly, the second reflectors 750 and 850 of the light emitting apparatuses 700 and 800 of the present embodiment may have a same effect as that of the second reflector 550 of the light emitting apparatus (500 of FIG. 9) of the fifth embodiment. For example, an inner surface angle θ4 may be 45 degrees or more and less than 90 degrees.

In addition, the second reflectors 750 and 850 of the seventh and eighth embodiments may include the flat upper surface.

In addition, the second reflectors 750 and 850 of the present embodiments may be formed such that an outer surface thereof is in close contact with an inner surface of the light transmitting layer 330. That is, the second reflectors 750 and 850 may be formed such that an end of the upper surface or an outer edge of the upper surface is in close contact with the inner surface of the light transmitting layer 330.

In addition, when the upper surface of the second reflectors 750 and 850 is an inclined surface, an outer surface angle θ₃ of the second reflectors 750 and 850 may be similar to an angle θ₅ formed by the upper surface of the second reflectors 750 and 850 and the side surface of the light transmitting layer 330 by difference in less than 15 degrees. The outer surface angle θ₃ of the second reflector 750 or 850 may be an internal angle formed by the second reflector 750 or 850 and the upper surface of the substrate 110.

The flat upper surface of the second reflectors 750 and 850 may reflect light reflected or refracted from an interface of the first reflector 440 or the light transmitting layer 330 to proceed in a downward direction such that light is emitted to the outside of the light transmitting layer 330 in a region higher than the substrate 100 or the second reflector 750 or 850. In addition, since the second reflectors 750 and 850 reflect light directed downward to be directed toward the side surface of the light transmitting layer 330 at a position higher than the substrate 110, a movement path of light may be decreased, thereby reducing light loss.

Accordingly, the light emitting apparatuses 700 and 800 of the seventh and eighth embodiments may prevent or minimize that light reflected or refracted from the interface of the first reflector 440 or the light transmitting layer 330 to proceed in the downward direction and be emitted to the outside of the light emitting apparatuses 700 and 800 at a height lower than that of the second reflector 750 or 850. That is, the light emitting apparatuses 700 and 800 of the present embodiments may prevent or minimize light from being emitted in the downward direction of the light emitting apparatuses 700 and 800 by the second reflectors 750 and 850, thereby reducing a main exiting angle and allowing radiation characteristics thereof to have a narrow angle. Herein, the angle of the radiation characteristics is an angular difference between a maximum angle and a minimum angle when a relative illuminance is 0.5.

FIG. 12 is a graph of radiation characteristics of the light emitting apparatus (700 of FIG. 11) according to the seventh embodiment of the present disclosure.

Referring to FIG. 12, it can be confirmed that the light emitting apparatus of the seventh embodiment (700 of FIG. 11) does not emit light in the downward direction, but mainly emits light in a side direction. For example, the light emitting apparatus (700 in FIG. 11) may have a relative luminous intensity of 0.5 or less in a region of -90 degrees or less or 90 degrees or more based on the radiation characteristics.

Referring to FIG. 13, the second reflector 850 of the light emitting apparatus 800 of the eighth embodiment has a structure having the upper surface with different heights. That is, the second reflector 850 of the eighth embodiment has the upper surface formed with a multi-stepped structure. For example, the second reflector 850 may be divided into a first region 851 and a second region 852 having different heights on the upper surface. The first region 851 may be positioned over the second region 852, and may have a thickness smaller than that of the second region 852. Accordingly, an upper surface height of the first region 851 may be positioned higher than that of the second region 852. In addition, the second region 852 may have a region of the upper surface covered with the first region 851, and another region of the upper surface may be exposed and in contact with the light transmitting layer 330.

According to the present embodiment, the first region 851 may be positioned close to an inner surface in the second reflector 850. That is, an end of the upper surface of the second region 852 exposed to the outside may be in contact with the outer surface of the second reflector 850.

An outer surface of the first region 851 of the second reflector 850 may reflect light directed from an outer surface or an outer upper side of the first region 851 toward the outer surface of the first region 851 to be directed toward the side surface of the light transmitting layer 330.

In addition, the outer surface of the first region 851 of the second reflector 850 may be an inclined surface, and an angle θ₆ formed by the outer surface of the first region 851 and the upper surface of the second region 852 connected to each other may be an obtuse angle. In this case, an angle θ₄ of the inner surface of the second reflector 850 may be an acute angle, may differ by 5 degrees or more from the angle θ₆ formed by the outer surface of the first region 851 and the upper surface of the second region 852, and further, may differ by 10 degrees or more and 70 degrees or less. The light emitting apparatus 800 may emit light to the side surface by the inner surface of the second reflector 850 having such an angle.

By means of the multi-stepped structure of the second reflector 850, as described above, the light emitting apparatus 800 of the present embodiment may implement wider radiation characteristics than those of the light emitting apparatus (700 of FIG. 11) of the seventh embodiment.

In addition, in the second reflector 850, the first region 851, which is an upper region, may have a thickness smaller than the second region 852, which is a lower region. Herein, the thickness of the first region 851 is a distance from an inner surface of the first region 851 to the outer surface thereof, and a thickness of the second region 852 is a distance from an inner surface of the second region 852 to an outer surface thereof.

In the first region 851 having the relatively small thickness, a portion of light may be transmitted. In addition, the second region 852 having the relatively larger thickness may have light reflectivity higher than that of the first region 851. The light emitting apparatus 800 has a higher luminous intensity at the side surface than at the lower surface due to the second reflector 850 that transmits a portion of light in the upper region and reflects light in the lower region. Accordingly, the light emitting apparatus 800 may narrow a viewing angle through the second reflector 850.

Referring to FIG. 13, in the second reflector 850 of the present embodiment, the thin first region 851 may be surrounded by the light transmitting layer 330. Accordingly, the thin first region 851 may be protected from external impact by the light transmitting layer 330.

The second reflector 850 illustrated in FIG. 13 has a structure in which the inner surface of the first region 851 and the inner surface of the second region 852 are in contact, or vice versa. For example, the second reflector 850 may be formed with a structure in which the first region 851 having the smaller thickness than that of the second region 852 is disposed on the upper surface of the second region 852 and the outer surface of the first region 851 and the outer surface of the second region 852 are in contact. The second reflector 850 may narrow an emitting region of light emitted from the side surface of the light emitting apparatus 800, thereby obtaining narrower radiation characteristics than those of an opposite case.

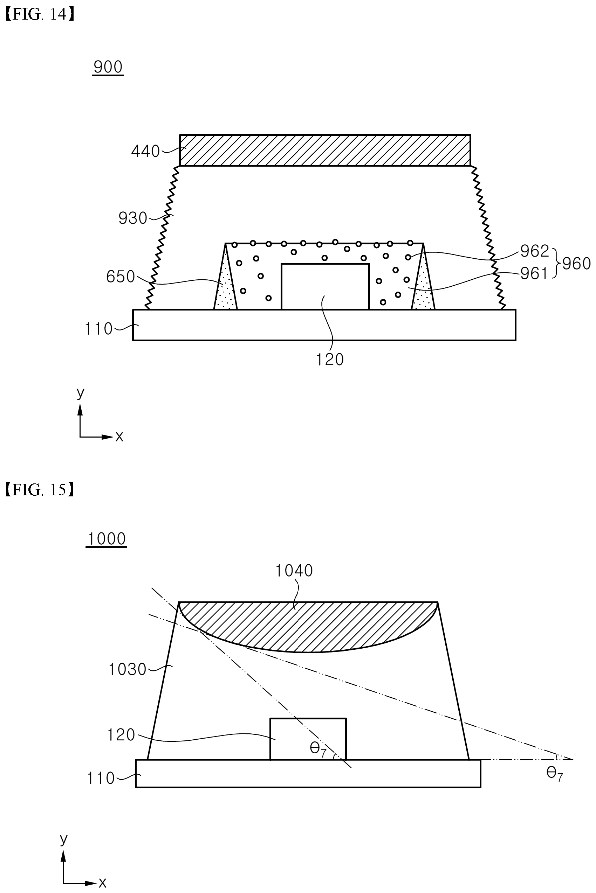

FIG. 14 is a schematic view illustrating a light emitting apparatus according to a ninth embodiment of the present disclosure.

A light emitting apparatus 900 according to the ninth embodiment includes a substrate 110, a light emitting device 120, a first light transmitting layer 930, a second light transmitting layer 960, a first reflector 440, and a second reflector 650. The light emitting apparatus 900 according to the ninth embodiment is the same as the light emitting apparatus (600 of FIG. 10) of the sixth embodiment in that it includes the substrate 110, the light emitting device 120, the first reflector 440, and the second reflector 650.

The first light transmitting layer 930 of the light emitting apparatus 900 of the ninth embodiment has a different side structure from that of the light transmitting layer 330 of the light emitting apparatus (600 of FIG. 10) of the sixth embodiment. Referring to FIG. 14, the light transmitting layer 930 of this embodiment may have a side surface formed with multiple irregularities. The side surface of the first light transmitting layer 930, which has an irregular structure, is a main emitting surface from which most of light of the light emitting apparatus 900 of this embodiment is emitted. The irregular structure of the first light transmitting layer 930 may reduce a total internal reflection of light on the side surface of the first light transmitting layer 930 by diversifying an incident angle of light on the side surface of the first light transmitting layer 930. Accordingly, the light emitting apparatus 900 of this embodiment may increase an amount of light emitted to a side direction by the first light transmitting layer 930 including the irregularities.

In addition, the light emitting apparatus 900 of the ninth embodiment may include the second light transmitting layer 960 that covers the light emitting device 120, and fills an inner space of the second reflector 650.

In the present embodiment, the second light transmitting layer 960 may include a light-transmitting material 961 and a filler 962 dispersed in the light-transmitting material 961. For example, the light-transmitting material 961 of the second light transmitting layer 960 may be epoxy resin, silicone resin, glass, or ceramic. The filler 962 of the second light transmitting layer 960 may be a wavelength conversion material, such as a fluorescent substance, quantum dot (QD), or the like. In addition, the filler 962 of the second light transmitting layer 960 may be a light diffuser. In addition, the filler 962 of the second light transmitting layer 960 may include at least one of the wavelength conversion material or the light diffuser. For example, the wavelength conversion material may be a quantum dot or a phosphor capable of emitting light having a peak wavelength in a green or yellow light wavelength range. In this case, the phosphor may include at least one of a LuAG series, a YAG series, a beta-SiAlON series, a nitride series, a silicate series, a halophosphate series, or an oxynitride series. In addition, the wavelength conversion material may be a quantum dot or a phosphor capable of emitting light having a peak wavelength in a red light wavelength range. In this case, the phosphor may include at least one of a nitride series, a silicate series, a sulfide series or a fluoride series, such as CASN, CASON, and SCASN. The wavelength conversion material included in the second light transmitting layer 960 is not limited to the types described above, and may be various types of materials already known that are capable of converting the wavelength of light.

Referring to FIG. 14, the second light transmitting layer 960 may have an interface with an irregular structure due to the filler 962 dispersed in the light-transmitting material 961. The irregular structure of the second light transmitting layer 960 may re-reflect light reflected from the interface of the first reflector 440 or the first light transmitting layer 930 and directed in a downward direction to the side direction of the first light transmitting layer 930. In addition, the irregular structure of the second light transmitting layer 960 may reduce a total internal reflection of light reaching an upper surface (an interface) inside the second light transmitting layer 960, similar to the irregular structure of the first light transmitting layer 930, thereby increasing an amount of light incident on the first light transmitting layer 930. In addition, the irregular structure of the second light transmitting layer 960 may reduce a number of reflections of light reflected inside the first light transmitting layer 930 and inside the second light transmitting layer 960, thereby preventing loss due to repeated reflection of light.

As such, the light emitting apparatus 900 of the present embodiment may improve light efficiency by increasing the amount of light emitted to the outside through the side surface by the first light transmitting layer 930 and the second light transmitting layer 960.

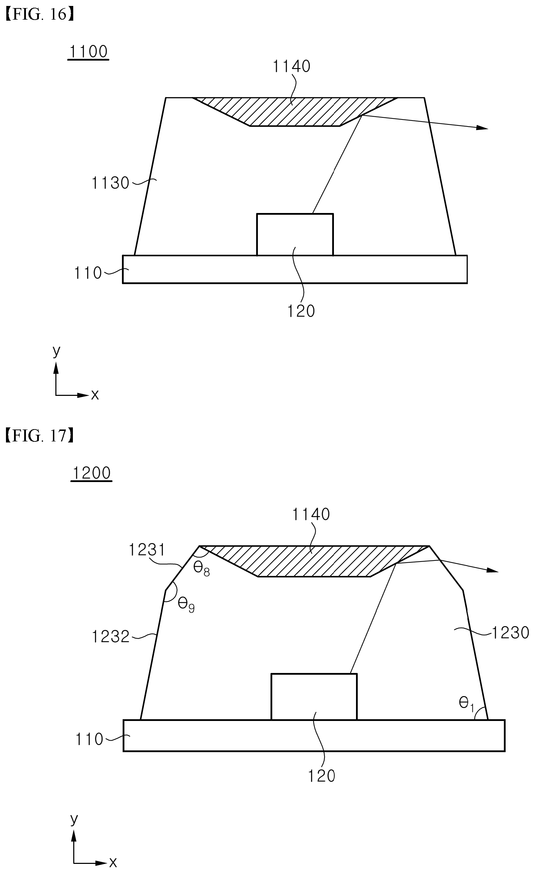

FIG. 15 is a schematic view illustrating a light emitting apparatus according to a 10th embodiment of the present disclosure. FIG. 16 is a schematic view illustrating a light emitting apparatus according to an 11th embodiment of the present disclosure.

Light emitting apparatuses 1000 and 1100 according to the 10th and 11th embodiments include a substrate 110, a light emitting device 120, light transmitting layers 1030 and 1130, and reflectors 1040 and 1140, respectively. The light emitting apparatuses 1000 and 1100 according to the 10th and 11th embodiments are the same as the light emitting apparatus (300 of FIG. 5) of the third embodiment in that they include the substrate 110 and the light emitting device 120. However, the light emitting apparatuses 1000 and 1100 of the 10th and 11th embodiments have structural differences in the light transmitting layers 1030 and 1130 and the reflectors 1040 and 1140 from the light transmitting layers 330 and the reflector 150 of the light emitting apparatus (300 of FIG. 5) of the third embodiment.

Referring to FIG. 15, the light transmitting layer 1030 of the light emitting apparatus 1000 of the 10th embodiment may be formed as a concave curved upper surface in a downward direction. In addition, referring to FIG. 16, the light transmitting layer 1130 of the light emitting apparatus 1100 of the 11th embodiment may include an inclined surface such that a region of an upper surface has a concave shape in a downward direction. That is, the light emitting apparatuses 1000 and 1100 of the 10th and 11th embodiments are formed such that at least regions of the upper surfaces of the light transmitting layers 1030 and 1130 are concave in the downward direction. Accordingly, the light transmitting layers 1030 and 1130 may have a structure in which a height of at least the region of the upper surfaces gradually decreases toward a center thereof.

Since the light transmitting layer 1030 of the light emitting apparatus 1000 of the 10th embodiment in FIG. 15 is formed as the concave curved upper surface, an angle θ₇ formed by a tangent line of the upper surface of the light transmitting layer 1030 and an upper surface of the substrate 110 or an extension line of the upper surface of the substrate 110 becomes smaller from an outer side of the light transmitting layer 1030 to a center thereof. Accordingly, a tangential angle at the center of the light transmitting layer 1030 becomes 0 degrees. In addition, the tangent line at the center of the light transmitting layer 1030 may be parallel to the upper surface of the substrate 110 or the light emitting device 120. In this case, the reflectors 1040 and 1140 may not reflect a portion of light incident in a direction perpendicular to the tangent line at the center of the light transmitting layer 1030, but may transmit the portion of the light. In this case, the light emitting apparatuses 1000 and 1100 may have a relative illuminance greater than 0 in a region near 0 degrees including 0 degrees based on radiation characteristics thereof.

In addition, since the light emitting apparatus 1100 of the 11th embodiment of FIG. 16 includes the inclined surface such that the upper surface of the light transmitting layer 1130 is concave, a lower surface of the reflector 1140 has an inclined surface that inclines in the downward direction toward a center thereof. Since an inclined surface of the lower surface of the reflector 1140 inclines in the downward direction toward the center thereof, an acute angle is formed with respect to the upper surface of the substrate 110.

The reflectors 1040 and 1140 of the light emitting apparatuses 1000 and 1100 of the 10th and 11th embodiments, respectively, are formed to cover the upper surfaces of the light transmitting layers 1030 and 1130. Accordingly, the reflectors 1040 and 1140 may include a structure in which at least regions of lower surfaces thereof are convex in the downward direction. Referring to FIG. 15, the reflector 1040 of the 10th embodiment may be formed as a convex curved lower surface in the downward direction. In addition, referring to FIG. 16, the reflector 1140 of the 11th embodiment may include an inclined surface such that the lower surface is convex in the downward direction.

Since the light transmitting layer 1030 of the light emitting apparatus 1000 of the 10th embodiment in FIG. 15 is formed as the concave curved upper surface, an angle θ₇ formed by a tangent line of the upper surface of the light transmitting layer 1030 or the lower surface of the reflector 1040 and the substrate 110 becomes smaller from the outer side of the light transmitting layer 1030 and the reflector 1040 to the center. Accordingly, a tangential angle at the center of the light transmitting layer 1030 and the reflector 1040 becomes 0 degrees.

In addition, at least regions of the reflectors 1040 and 1140 may have a thickness that increases from the outer side to an inner side. In addition, the reflectors 1040 and 1140 may have a maximum thickness in a region close to the upper surface of the light emitting device 120. The reflectors 1040 and 1140 of this structure may reflect light emitted from the upper surface of the light emitting device 120 to side surfaces of the light transmitting layers 1030 and 1130, thereby widening viewing angles of the light emitting apparatuses 1000 and 1100.

The downward convex structure of the reflectors 1040 and 1140 of the 10th and 11th embodiments may prevent light emitted from the light emitting device 120 from being reflected at the reflectors 1040 and 1140, respectively, in the downward direction where the light emitting device 120 and the substrate 110 are disposed. In addition, light may be reflected from the lower surfaces of the convex structure of the reflectors 1040 and 1140 and directed toward side surfaces of the light transmitting layer 1030 and 1130.

Accordingly, the light emitting apparatuses 1000 and 1100 of the 10th and 11th embodiments may enable light to be emitted to the outside through the side surfaces of the light transmitting layers 1030 and 1130 with a minimum reflection and travel distance by the reflectors 1040 and 1140 having the structure that is at least partially convex in the downward direction. In addition, the light emitting apparatuses 1000 and 1100 of the 10th and 11th embodiments may minimize light loss by minimizing a number of reflections of light within the light transmitting layers 1030 and 1130 by the reflectors 1040 and 1140.

FIG. 17 is a schematic view illustrating a light emitting apparatus according to a 12th embodiment of the present disclosure.

A light emitting apparatus 1200 according to the 12th embodiment includes a substrate 110, a light emitting device 120, a light transmitting layer 1230, and a reflector 1140. The light emitting apparatus 1200 according to the 12th embodiment is the same as the light emitting apparatus (1100 of FIG. 16) of the 11th embodiment in that it includes the substrate 110, the light emitting device 120, and the reflector 1140 However, the light transmitting layer 1230 of the light emitting apparatus 1200 in the 12th embodiment has a different structure from that of the light transmitting layer 1130 of the light emitting apparatus (1100 of FIG. 16) in the 11th embodiment.

The light transmitting layer 1230 of the light emitting apparatus 1200 in the 12th embodiment, unlike the light transmitting layer 1130 of the light emitting apparatus (1100 of FIG. 16) of the 11th embodiment, has an upper surface of an outer side of the reflector 1140 that has an inclination. That is, the upper surface of the light transmitting layer 1230 of the present embodiment has an inclined region adjacent to the outer side of the reflector 1140. Accordingly, the light emitting apparatus 1200 of the 12th embodiment has a structure in which an entire upper surface of the light transmitting layer 1230 is covered by the reflector 1140, and a side surface of the light transmitting layer 1230 is formed with different inclined surfaces.

Referring to FIG. 17, the light transmitting layer 1230 of the present embodiment may include a first inclined surface 1231 and a second inclined surface 1232 having different inclinations from each other. The light transmitting layer 1230 is formed with a first inclined surface 1231 where an upper region of the side surface forms an obtuse angle with the upper surface. In addition, the light transmitting layer 1230 is formed with the second inclined surface 1232 where a lower region of the side surface forms an obtuse angle with the lower surface. In this case, the second inclined surface 1232 having the obtuse angle with respect to the lower surface of the light transmitting layer 1230 or an upper surface of the substrate 110 may have a same effect as an effect in a case that the lower angle θ₁ of the light transmitting layer described in the previous embodiment is the obtuse angle. In addition, if the second inclined surface 1232 of the light transmitting layer 1230 forms the acute angle with respect to the lower surface of the light transmitting layer 1230 or the upper surface of the substrate 110, it may have a same effect as an effect in a case that the lower angle θ₁ of the light transmitting layer described in the previous embodiment is the acute angle.

The light transmitting layer 1230 has an angle θ₈ between the first inclined surface 1231 and the upper surface that may be smaller than an angle θ₉ between the first inclined surface 1231 and the second inclined surface 1232. In this case, the angle θ₉ between the first inclined surface 1231 and the second inclined surface 1232 may be an obtuse angle. In addition, the angle θ₈ between the first inclined surface 1231 and the upper surface and the angle θ₉ of the first inclined surface 1231 and the second inclined surface 1232 may be greater than an angle formed by an inclined surface or an extension line of the inclined surface of the reflector 1140 based on the substrate 110. In addition, the angle θ₉ between the first inclined surface 1231 and the second inclined surface 1232 may be greater than a lower angle θ₁ of the light transmitting layer 1230.

According to the present embodiment, light reflected from the lower surface of the reflector 1140 and directed in an upward direction may be refracted toward a horizontal center line of the light emitting apparatus 1200 from the first inclined surface 1231 of the side surface of the light transmitting layer 1230. Accordingly, the light emitting apparatus 1200 of the present embodiment may minimize an amount of light proceeding in the upward direction through the side surface of the light transmitting layer 1230, and increase an amount of light emitted in a side direction, by having the structure in which the side surface of the upper region of the light transmitting layer 1230 is formed as the inclined surface having the obtuse angle with the upper surface.

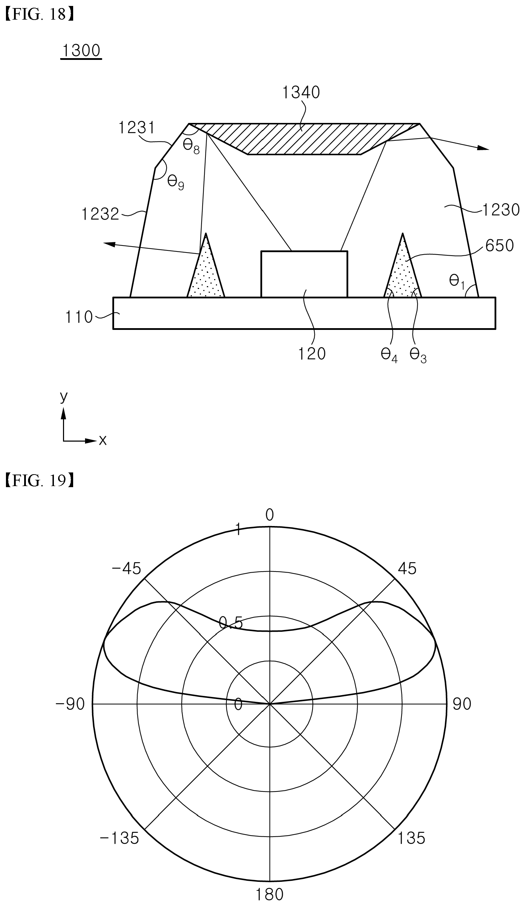

FIGS. 18 and 19 are diagrams illustrating a light emitting apparatus according to a 13th embodiment of the present disclosure.

FIG. 18 is a schematic view illustrating a light emitting apparatus 1300 according to the 13th embodiment of the present disclosure.

The light emitting apparatus 1300 according to the 13th embodiment of the present disclosure includes a substrate 110, a light emitting device 120, a light transmitting layer 1230, a first reflector 1340, and a second reflector 650. Herein, the substrate 110, the light emitting device 120, the light transmitting layer 1230, and the first reflector 1340 of the light emitting apparatus 1300 of the 13th embodiment are the same as the substrate 110, the light emitting device 120, the light transmitting layer 1230, and the reflector 1140 of the light emitting apparatus (1200 of FIG. 17) of the 12th embodiment, respectively. That is, the light emitting apparatus 1300 according to the 13th embodiment of the present disclosure is the light emitting apparatus of the 12th embodiment (1200 of FIG. 17) with the second reflector 650 added.

Accordingly, the light emitting apparatus 1300 of the present embodiment may have all of effects of the reflector (1140 of FIG. 16) of the 11th embodiment, the light transmitting layer (1230 of FIG. 17) of the 12th embodiment and the second reflector (650 of FIG. 10) of the sixth embodiment.

In addition, an angle θ₈ between a first inclined surface 1231 of the light transmitting layer 1230 and an upper surface or an angle θ₉ between the first inclined surface 1231 and a second inclined surface 1232 may be greater than an angle θ₃ formed by a lower surface and an outer surface of the second reflector 650 and an angle θ₄ formed by the lower surface and an inner surface of the second reflector 650.

FIG. 19 is a graph of radiation characteristics of the light emitting apparatus according to the 13th embodiment of the present disclosure.

Referring to FIG. 19, the light emitting apparatus (1300 of FIG. 18) according to the 13th embodiment minimizes light emission in a downward direction by the second reflector 650, and intensively emits light in a side direction by the first reflector 1340 and the light transmitting layer 1230.

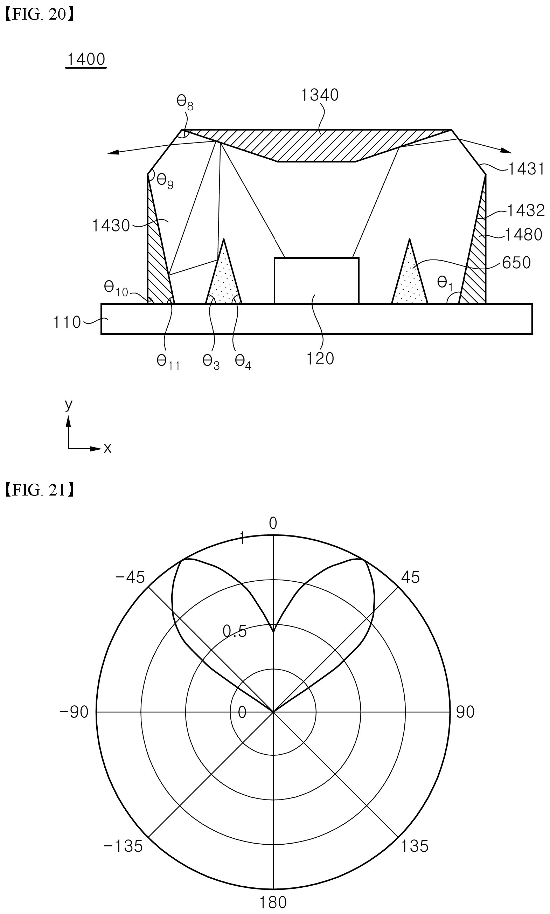

FIGS. 20 and 21 are diagrams illustrating a light emitting apparatus according to a 14th embodiment of the present disclosure.

FIG. 20 is a schematic view illustrating a light emitting apparatus 1400 according to the 14th embodiment of the present disclosure.

The light emitting apparatus 1400 according to the 14th embodiment of the present disclosure includes a substrate 110, a light emitting device 120, a light transmitting layer 1430, a first reflector 1340, a second reflector 650, and a third reflector 1480. Herein, the substrate 110, the light emitting device 120, the first reflector 1340, and the second reflector 650 of the light emitting apparatus 1400 of the 14th embodiment are identical to the substrate 110, the light emitting device 120, the first reflector 1340, and the second reflector 650 of the light emitting apparatus (1300 of FIG. 18) of the 13th embodiment, respectively.

In the present embodiment, a side surface of the light transmitting layer 1430 may include a first inclined surface 1431 that is inclined outwardly from an upper surface toward a lower surface, and a second inclined surface 1432 that is inclined inwardly from the first inclined surface 1431 toward the lower surface. A top of the first inclined surface 1431 is connected with the upper surface of the light transmitting layer 1430, and a bottom is connected with the second inclined surface 1432. In addition, a bottom of the second inclined surface 1432 is connected with the lower surface of the light transmitting layer 1430.

The third reflector 1480 may be formed to cover a region of the side surface of the light transmitting layer 1430 in the outside of the light transmitting layer 1430. That is, the third reflector 1480 may be disposed to cover a region of an outer surface of the light transmitting layer 1430. Referring to FIG. 20, the third reflector 1480 may be disposed to cover the second inclined surface 1432, which is a lower region of the side surface of the light transmitting layer 1430. Accordingly, light directed toward the second inclined surface 1432 of the light transmitting layer 1430 may be not emitted to the outside of the light emitting apparatus 1400 by the fourth reflector 1480, but may be reflected into the inside of the light transmitting layer 1430. Accordingly, a main emitting surface of the light emitting apparatus 1400 of the present embodiment may be the first inclined surface 1431 of the light transmitting layer 1430.

The third reflector 1480 may be formed of a material that reflects at least a portion of light moving the inside of the light transmitting layer 1430. For example, the third reflector 1480 may be formed of metal. Alternatively, the third reflector 1480 may include a light-transmitting material and a light reflective material dispersed in the light-transmitting material. For example, the light-transmitting material may be an epoxy resin, a silicone resin, glass, or a ceramic. In addition, the light reflective material may include at least one of TiO₂, BaSO₄, or Silica. Alternatively, the third reflector 1480 may be a distributed Bragg reflector (DBR) formed by stacking a plurality of layers in which at least one thereof has a different refractive index. Alternatively, the third reflector 1480 may be an omni-directional reflector. Alternatively, the third reflector 1480 may be formed to include a plurality of third reflectors 1480 described above. In addition, the third reflector 1480 may have its light transmittance rate changed as needed. That is, the third reflector 1480 may reflect all light with a light transmittance rate of 0%, or may reflect a portion of light and transmit another portion of light with a light transmittance rate exceeding 0%.

In an embodiment, the third reflector 1480 has an angle θ₁₀ between a lower surface and an outer surface that may be greater than an angle θ₁₁ between the lower surface and an inner surface. In this case, when light proceeds from the inside to the outer surface of the third reflector 1480, light with an angle with the outer surface of the third reflector 1480 that is smaller than an angle of a total internal reflection may increase, thereby decreasing the total internal reflection of light on the outer surface of the third reflector 1480. Accordingly, the light transmittance rate on the outer surface of the third reflector 1480 may increase, thereby increasing a light extraction efficiency of a side surface of the light emitting apparatus 1400.

In another embodiment, the third reflector 1480 has the angle θ₁₀ of the outer surface that may be smaller than the angle θ₁₁ of the inner surface. In this case, when light passes through the outer surface of the third reflector 1480, light emitted perpendicular to the outer surface may increase. Accordingly, the light emitting apparatus 1400 may have radiation characteristics with a wide beam angle. That is, the light emitting apparatus 1400 may have wide radiation characteristics.

In addition, the angle θ₉ between the first inclined surface 1431 and the second inclined surface 1432 of the light transmitting layer 1430 may be greater than the outer surface angle θ₁₀ of the third reflector 1480 and inner surface angle θ₁₁. Such a structure may reduce the total internal reflection on the first inclined surface 1431 by making an incident angle of light on the first inclined surface 1431 smaller than a critical angle. Accordingly, light emitted through the first inclined surface 1431 may increase.

FIG. 21 is a graph of the radiation characteristics of the light emitting apparatus according to the 14th embodiment of the present disclosure.

Referring to FIG. 21, it can be seen that the light emitting apparatus (1400 of FIG. 20) according to the 14th embodiment mainly emits light in a direction of -45 degrees or more and less than 0 degrees and more than 0 degrees and 45 degrees or less. That is, the light emitting apparatus (1400 in FIG. 20) of the 14th embodiment mainly emits light in a direction of an upper region of the side surface.

Such a light emission is because the light emitting apparatus (1400 in FIG. 20) suppresses the light emission in a lower direction by the third reflector 1480 and a lower direction of the side surface, and most of light is emitted from the upper region of the side surface where the third reflector 1480 is not present.

As such, the light emitting apparatus (1400 of FIG. 20) according to the 14th embodiment may control a light-emitting region through the third reflector 1480.

In FIG. 20, the third reflector 1480 is formed to cover an entire second inclined surface 1432 of the light transmitting layer 1430, but a region where the third reflector 1480 is formed may be changed in various ways. For example, the third reflector 1480 may be disposed to cover a region of the second inclined surface 1432 of the light transmitting layer 1430, or to cover all or a region of the first inclined surface 1431. Alternatively, the third reflector 1480 may be disposed to cover a region of each of the first inclined surface 1431 and the second inclined surface 1432 of the light transmitting layer 1430. Alternatively, the third reflector 1480 may be formed to cover all of one of the first inclined surface 1431 and the second inclined surface 1432 of the light transmitting layer 1430 and to cover a region of the other.

As such, the light emitting apparatus (1400 of FIG. 20) according to the 14th embodiment may control various light emitting characteristics of the light emitting apparatus, such as a light-emitting direction, a light-emitting angle, a light-emitting shape, and the like, by having the third reflector 1480 cover a region excluding the main emitting surface on a side surface of the light transmitting layer 1430.

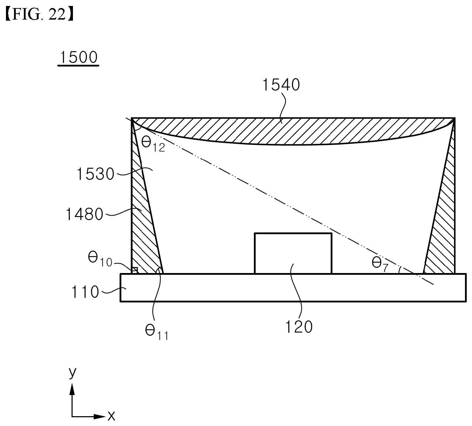

FIG. 22 is a schematic view illustrating a light emitting apparatus according to a 15th embodiment of the present disclosure.

A light emitting apparatus 1500 according to the 15th embodiment of the present disclosure may include a substrate 110, a light emitting device 120, a light transmitting layer 1530, a first reflector 1540, and a third reflector 1480. In addition, the third reflector 1480 of the light emitting apparatus 1500 of the present embodiment includes the same features as those of the third reflector 1480 of the light emitting apparatus (1400 of FIG. 20) of the 14th embodiment.

Moreover, as a thickness of the third reflector 1480 decreases, a transmittance of the third reflector may increase. Accordingly, the transmittance of the third reflector 1480 may increase from a bottom to a top thereof. The light emitting apparatus 1500 of the present embodiment may obtain radiation characteristics having a higher luminous intensity at -80 degrees to -45 degrees and 80 to 45 degrees than at -90 degrees to -80 degrees and 80 degrees to 90 degrees by adjusting a thickness of each region of the third reflector 1480.

In addition, a structure in which the third reflector 1480 covers an entire side surface of the light transmitting layer 1530 may adjust the luminous intensity emitted by each region of a side surface of the light emitting apparatus 1500, by adjusting the thickness of each region of the third reflector 1480. Furthermore, a difference in luminous intensity depending on a direction of the light emitting apparatus 1500 may be reduced. For example, radiation characteristics based on a direction of another side surface opposite to a side surface of the light emitting apparatus 1500 and radiation characteristics based on a direction of the other edge opposite to an edge of the light emitting apparatus 1500 may have a difference of less than 10% between a maximum luminous intensity per angle.

In the present embodiment, the light transmitting layer 1530 has a side surface formed as an inclined surface that is inclined inwardly from the top to the bottom.

In addition, an upper angle θ₁₂ that is an angle formed by a tangent line between the side surface and an upper surface of the light transmitting layer 1530 may be an acute angle. The upper angle θ₁₂ of the light transmitting layer 1530 may be smaller than an angle θ₁₀ between a lower surface and an outer surface of the third reflector 1480 and an angle θ₁₁ between the lower surface and an inner surface of the third reflector 1480. In addition, the upper angle θ₁₂ of the light transmitting layer 1530 may be greater than an angle θ₇ formed by the tangent line of the upper surface of the light transmitting layer 1530 and the substrate 110.

The light emitting apparatuses described through various embodiments of the present disclosure may further include an additional wavelength converter. The wavelength converter may be disposed on at least a region of the light emitting device, and may be disposed on at least a region of the light transmitting layer. The wavelength converter may include a wavelength conversion material that absorbs light from the light emitting device and emits light of a different wavelength than absorbed light. Herein, the wavelength conversion material may include at least one of a phosphor, a quantum dot, an organic dye, or a nonlinear optical converter.

For example, the wavelength conversion material may be a quantum dot or a phosphor capable of emitting light having a peak wavelength in a green or yellow light wavelength range. In this case, the phosphor may include at least one of a LuAG series, a YAG series, a beta-SiAlON series, a nitride series, a silicate series, a halophosphate series, or an oxynitride series.

In addition, the wavelength conversion material may be a quantum dot or a phosphor capable of emitting light having a peak wavelength in a red light wavelength range. In this case, the phosphor may include at least one of a nitride series, a silicate series, a sulfide series, or a fluoride series such as CASN, CASON, and SCASN.

However, the wavelength conversion material is not limited to the types described above, and various types of wavelength conversion materials already known according to a color of light emitted may be applied to the present disclosure.

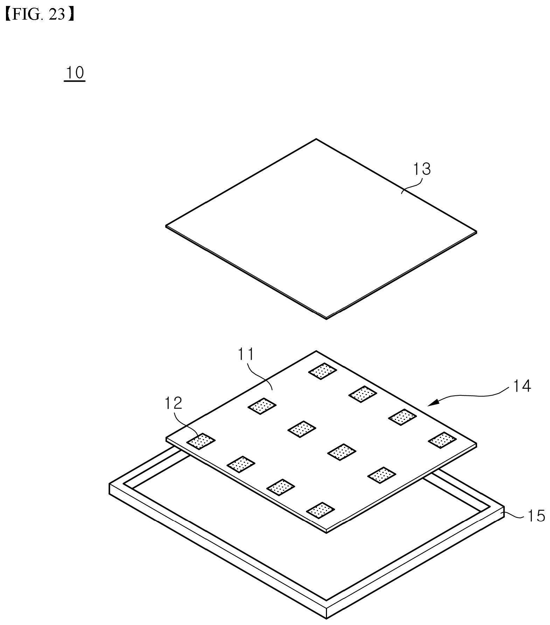

FIG. 23 is a diagram schematically illustrating a lighting apparatus according to an embodiment of the present disclosure.

Referring to FIG. 23, a lighting apparatus 10 may include a main body 15, an optical sheet 13, and a light emitting module 14.

The light emitting module 14 may be disposed inside the main body 15. In addition, various components such as devices and interconnections for an operation of the light emitting module 14 may be disposed inside the main body 15. In addition, although not shown in the drawings, a heat sink and a socket connected to an external power source may be formed or disposed inside the main body 15.

The light emitting module 14 may include a module substrate 11 and at least a light emitting unit 12.

At least a light emitting unit 12 may be mounted over the module substrate 11.

For example, a single light emitting unit 12 may be mounted on the module substrate 11. In this case, the light emitting unit 12 may be a light emitting apparatus described through FIGS. 1 to 22, or may be formed by a combination of components forming these light emitting apparatuses.

In addition, as shown in FIG. 23, a plurality of light emitting units 12 may be disposed in a plurality of rows and columns over the module substrate 11. In addition, the plurality of light emitting units 12 may include at least one of the light emitting apparatuses described through FIGS. 1 to 22. In addition, the plurality of light emitting units 12 may all be configured with the same light emitting apparatuses. In this case, the plurality of light emitting units 12 may be formed by one of the light emitting apparatuses described through FIGS. 1 to 22 or by a combination of components formed by these light emitting apparatuses.

Alternatively, the light emitting module 14 may be one of the light emitting apparatuses previously described through various embodiments. That is, the substrate of the light emitting apparatus of FIGS. 1 to 22 corresponds to the module substrate 11 of the light emitting module 14, and components formed over the substrate of the light emitting apparatus may correspond to the light emitting unit 12 of the light emitting module 14. That is, the light emitting unit 12 includes a light emitting device, a first light transmitting layer and a first reflector, and may include at least one of a second light transmitting layer, a second reflector, or a third reflector.

In this case, the single light emitting unit 12 may be mounted on the module substrate 11, or the plurality of light emitting units 12 may be mounted. When there is the plurality of light emitting units 12, structures of all light emitting units 12 may be the same, and at least a light emitting unit 12 may have a different structure from the other light emitting units 12.

As such, the light emitting module 14 of the present embodiment may be formed in various ways by applying the components of various light emitting apparatuses described previously.

The optical sheet 13 may include a light-transmitting material and a filler dispersed inside the light-transmitting material. Herein, the filler of the optical sheet 13 may be a light diffusing material.

The optical sheet 13 may evenly disperse light emitted from the light emitting module 14 to ensure that an illuminance is constant in a region within a beam angle of the lighting apparatus 10.

According to the present embodiment, the optical sheet 13 may be combined with the main body 15 to cover the light emitting module 14. In this case, the optical sheet 13 may be disposed parallel to a side surface of the module substrate 11 on which the light emitting unit 12 is disposed. In this case, the optical sheet 13 may also be disposed parallel to the reflectors of the light emitting apparatuses (100 ~1500 of FIGS. 1 to 22). The optical sheet 13 may receive light emitted from a side surface of the light emitting apparatus over a large area, thereby increasing light receiving efficiency.

The lighting apparatus 10 of the present embodiment may have a wide beam angle by applying the light emitting apparatuses of the various embodiments described previously. For example, the beam angle of the lighting apparatus 10 may be 90 degrees to 170 degrees.

The lighting apparatus 10 illustrated in FIG. 23 has a flat shape, but the lighting apparatus 10 may be formed in various shapes.

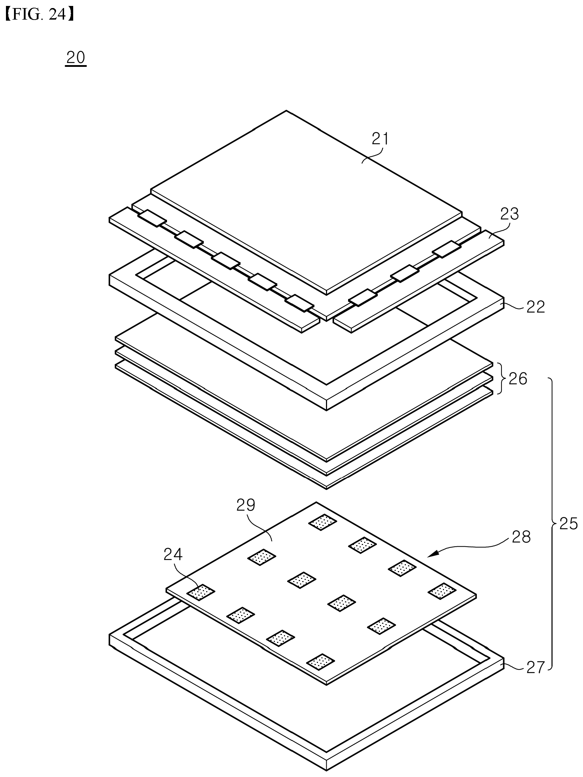

FIG. 24 is a diagram schematically illustrating a display apparatus according to an embodiment of the present disclosure.

According to the present embodiment, a display apparatus 20 may include a display panel 21, a panel guide 22, and a backlight unit 25. In addition, although not shown in the drawings, the display apparatus 20 of the present embodiment may further include a top cover that covers an upper edge of the display panel 21 and is combined with the backlight unit 25.

The display panel 21 may include a thin film transistor substrate, a color filter substrate, and a liquid crystal layer interposed between the thin film transistor substrate and the color filter substrate, which are bonded to be opposite to one another and maintain a uniform cell gap.

A driver board 23 that supplies driving signals to gate lines and data lines may be positioned at the edge of the display panel 21. The driver board 23 is electrically connected to the display panel 21 by at least one of a COF (Chip On Film) or a TCP (Tape Carrier Package).

The backlight unit 25 may include optical sheets 26, a cover 27, and a light emitting module 28.

The cover 27 may have an open upper surface, and may store the light emitting module 28 and the optical sheets 26 inside it.

The light emitting module 28 may include a module substrate 29 and at least a light emitting unit 24. The light emitting module 28 of the present embodiment may be identical to the light emitting module 14 described in FIG. 23. That is, the module substrate 29 and the light emitting unit 24 of the light emitting module 28 of the present embodiment may have same features as those of the module substrate 11 and the light emitting unit 12 of the light emitting module 14 described in FIG. 23, respectively. The light emitting module 28 of the display apparatus 20 of the present embodiment may be formed of the light emitting apparatuses described through FIGS. 1 to 22 or may be formed in various ways by a combination of their components.

The optical sheets 26 may include at least one of a diffusion sheet, a light collection sheet, or a protection sheet. The optical sheets 26 may include a sheet each or plural sheets of the diffusion sheets, the light collection sheets, and the protection sheets, respectively, or may include a sheet or plural sheets of at least one of the diffusion sheets, the light collection sheets, or the protection sheets. For example, the optical sheets 26 may be configured with a diffusion sheet and two light collection sheets, or may be configured with two diffusion sheets and a light collection sheet.

The optical sheets 26 may be disposed parallel to the light emitting module 14. Furthermore, the optical sheets 26 may be disposed parallel to a side surface of the light emitting unit 24 or the module substrate 29 on which the light emitting unit 24 is mounted.

The display apparatus 20 according to the present embodiment includes the light emitting unit 24 having a wide viewing angle or a beam angle, and the optical sheet 26 is disposed parallel to the light emitting unit 24 or the light emitting module 28 having the light emitting unit 24, and thus, a uniform illuminance may be achieved even over a wide area. Accordingly, the display apparatus 20 of the present embodiment may have the wide viewing angle to have consistent quality at various angles even when it is formed over a large area.

In addition, the backlight unit 25 may further include a reflection sheet (not shown in the drawings). The reflection sheet may be formed to cover an upper surface of the module substrate 29 of the light emitting module 28, or may be disposed under the module substrate 29. The reflection sheet may reflect light directed toward downward direction of the optical sheets 26 or downward direction of the light emitting module 28 toward the optical sheets 26.

The light emitting apparatus having the features described through the embodiments of the present disclosure may be applied as a light source for various apparatuses such as a display apparatus, a backlight unit of a display apparatus, a lighting apparatus, and the like.

As described above, the detailed description of the present disclosure has been made by way of examples with reference to the accompanying drawings, however, since the above-described embodiments are only described as preferred examples of the present disclosure, the present disclosure should not be understood as being limited to the embodiments, and the scope of rights of the present disclosure should be understood in terms of the claims described below and their equivalent concepts.

## Claims

1. A light emitting apparatus, comprising:
a substrate;
a light emitting device disposed on the substrate, and emitting light;
a first light transmitting layer disposed on the substrate to cover the light emitting device, and formed of a material that transmits the light emitted from the light emitting device; and
a first reflector disposed on at least a region of an upper surface of the first light transmitting layer, and reflecting at least a portion of the light,
wherein a side surface of the first light transmitting layer includes an inclined surface.

2. The light emitting apparatus of claim 1, wherein the side surface of the first light transmitting layer forms an obtuse angle with a lower surface of the first light transmitting layer.

3. The light emitting apparatus of claim 1, wherein the side surface of the first light transmitting layer forms an acute angle with a lower surface of the first light transmitting layer.

4. The light emitting apparatus of claim 1, wherein irregularities are formed on the side surface of the first light transmitting layer.

5. The light emitting apparatus of claim 1, wherein the first reflector is formed such that a lower surface thereof is in contact with the upper surface of the first light transmitting layer.

6. The light emitting apparatus of claim 5, wherein the first light transmitting layer has a structure in which the upper surface has a flat region.

7. The light emitting apparatus of claim 5, wherein:
the first light transmitting layer has a structure in which at least a region of the upper surface is concave in a downward direction, and
the first reflector has a structure with a flat upper surface.

8. The light emitting apparatus of claim 7, wherein the lower surface of the first reflector is a curved surface.

9. The light emitting apparatus of claim 7, wherein at least a region of the lower surface of the first reflector is an inclined surface.

10. The light emitting apparatus of claim 1, wherein the side surface of the first light transmitting layer is formed with different inclined surfaces.

11. The light emitting apparatus of claim 10, wherein an upper region of the side surface of the first light transmitting layer includes a first inclined surface forming an obtuse angle with the upper surface of the first light transmitting layer, and a lower region of the side surface thereof includes a second inclined surface forming an obtuse angle with a lower surface of the first light transmitting layer.

12. A light emitting apparatus, comprising:
a substrate;
a light emitting device disposed on the substrate, and emitting light;
a first light transmitting layer disposed on the substrate to cover the light emitting device, and formed of a material that transmits the light emitted from the light emitting device;
a first reflector disposed to cover at least a region of an upper surface of the first light transmitting layer, and configured to reflect at least a portion of the light; and
a second reflector disposed on the substrate inside the first light transmitting layer, and at least partially surrounding a side surface of the light emitting device;
wherein a side surface of the first light transmitting layer is a main emitting surface through which the light of the light emitting device is emitted to an outside of the light emitting apparatus,
wherein the side surface of the first light transmitting layer includes an inclined surface,
and
wherein an inner surface of the second reflector and the side surface of the light emitting device are spaced apart.

13. The light emitting apparatus of claim 12, wherein the second reflector reflects a portion of the light and transmits another portion of the light.

14. The light emitting apparatus of claim 12, wherein at least one of the inner surface or an outer surface of the second reflector is an inclined surface forming an acute angle with a lower surface of the second reflector.

15. The light emitting apparatus of claim 12, wherein the second reflector includes a flat upper surface.

16. The light emitting apparatus of claim 12, further comprising a second light transmitting layer formed in an inner space of the second reflector to cover the light emitting device, and transmitting the light.

17. The light emitting apparatus of claim 16, wherein the second light transmitting layer further comprises a filler.

18. The light emitting apparatus of claim 17, wherein an upper surface of the second light transmitting layer has an irregular structure due to the filler.

19. The light emitting apparatus of claim 17, wherein the filler comprises at least one of a wavelength conversion material or a light diffuser.

20. A display apparatus, comprising:
a substrate;
a light emitting device disposed on the substrate, and emitting light;
a first light transmitting layer disposed on the substrate to cover the light emitting device, and formed of a material that transmits the light emitted from the light emitting device;
a first reflector disposed on at least a region of an upper surface of the first light transmitting layer, and configured to reflect at least a portion of the light; and
an optical sheet disposed parallel to the light emitting device,
wherein a side surface of the first light transmitting layer is a main emitting surface through which the light of the light emitting device is emitted to an outside of the apparatus, and
wherein the side surface of the first light transmitting layer includes an inclined surface.
